# DEMANDE DE BREVET EUROPEEN

(11) **EP 4 661 064 A1**
(43) Date de publication de la demande: **10.12.2025**
(21) Numéro de dépôt: 25178552.3
(22) Date de dépôt: 23.05.2025
(51) Int. Cl.: H01L 21/66, H01L 23/58

(54) **DISPOSITIF DE DETECTION DE FISSURE DANS UNE STRUCTURE SEMICONDUCTRICE**

(30) Priorité: 07.06.2024 FR 2406023
(71) Demandeur: STMicroelectronics International N.V., 1228 Plan-les-Ouates, Geneva (CH)
(72) Inventeur: SUAREZ SEGOVIA, Carlos Augusto, 38170 Seyssinet-Pariset (FR); MARZAKI, Abderrezak, 13480 Cabries (FR); TROUILLER, Chantal, 38000 Grenoble (FR)
(74) Mandataire: Cabinet Beaumont

(57) **Abrégé**

La présente description concerne un dispositif de détection de fissure (200) adapté à détecter une fissure dans une puce électronique, le dispositif de détection de fissure comprenant une première ligne conductrice (201) pour détecter une fissure dans une structure semiconductrice (210) située dans, et/ou sur, un substrat semiconducteur (211), une structure d'interconnexion (220) étant reliée à une première face (210A) de la structure semiconductrice, la première ligne conductrice étant comprise dans la structure d'interconnexion et dans la structure semiconductrice, et comprenant :
- au moins un premier segment conducteur (221A) et au moins un deuxième segment conducteur (221B) d'un premier niveau de métallisation (M1) de la structure d'interconnexion électriquement isolés entre eux par une couche isolante (223) ;
- une région conductrice enterrée (213) en profondeur dans la structure semiconductrice, ladite région conductrice enterrée étant reliée à un du au moins un premier segment conducteur et un du au moins un deuxième segment conducteur ;
- une région isolante (215) positionnée entre la première face de la structure semiconductrice et la région conductrice enterrée.

## Description

### Domaine technique

La présente description concerne de façon générale la détection de défauts, tels que des fissures ou des délaminations, dans une puce électronique, et en particulier dans une structure semiconductrice formée dans, et/ou sur, un substrat semiconducteur de la puce électronique.

La présente description concerne par exemple la détection de fissures qui peuvent se propager depuis un bord d'une puce électronique vers des circuits électroniques de la puce électronique.

### Technique antérieure

Dans l'industrie, la plupart des dispositifs électroniques sont fabriqués par série. De manière générale, plusieurs exemplaires d'un dispositif électronique sont fabriqués simultanément dans et sur un même substrat semiconducteur, par exemple une même plaque ou une même tranche semiconductrice, appelée "wafer" en anglais. En particulier, plusieurs puces électroniques sont généralement fabriquées dans et sur un même substrat semiconducteur, par exemple une même plaque ou une même tranche semiconductrice. Les puces électroniques peuvent ensuite être séparées, ou individualisées, pour pouvoir être utilisées, par exemple seules ou dans un dispositif électronique plus complet. Cette individualisation est généralement réalisée par découpe, par exemple par découpe laser.

Lors de cette individualisation, par exemple lors d'une découpe de la tranche semiconductrice, des défauts de structure peuvent se produire sur un bord d'une puce électronique. Parmi ces défauts peuvent être des fissures, des brèches, ou des délaminations. De tels défauts peuvent conduire à une défaillance des circuits électroniques de la puce électronique.

En outre, même si des défauts n'apparaissent pas lors de la fabrication, certains défauts peuvent apparaître pendant la durée de vie de la puce, en particulier sur un bord de la puce, par exemple en raison des modifications de température de la puce électronique.

Pour détecter une fissure, ou une délamination, dans une puce électronique, en particulier lors de la fabrication, de l'individualisation, voire lors de sa durée de vie, la puce électronique peut inclure un détecteur de fissure dans sa périphérie, le détecteur de fissure étant généralement positionné dans un anneau de scellement au niveau de la périphérie de la puce électronique. Un objet du détecteur de fissure est de détecter une fissure, ou une délamination, qui pourrait se propager depuis le bord jusqu'à une région de circuits électroniques de la puce électronique.

Il serait souhaitable de pouvoir améliorer, au moins en partie, les détecteurs de fissure des puces électroniques.

### Résumé de l'invention

Un mode de réalisation pallie tout ou partie des inconvénients des détecteurs de fissure de puces électroniques connus.

Un mode de réalisation prévoit un dispositif de détection de fissure adapté à détecter une fissure dans une puce électronique, le dispositif de détection de fissure comprenant une première ligne conductrice pour détecter une fissure dans au moins une structure semiconductrice située dans, et/ou sur, un substrat semiconducteur, une structure d'interconnexion étant reliée à une première face de la au moins une structure semiconductrice, la première ligne conductrice étant comprise dans la structure d'interconnexion et dans la au moins une structure semiconductrice, et comprenant :
- au moins un premier segment conducteur et au moins un deuxième segment conducteur, lesdits au moins un premier et deuxième segments conducteurs étant d'un premier niveau de métallisation de la structure d'interconnexion et étant électriquement isolés entre eux par une couche isolante ; et
- une région conductrice enterrée en profondeur dans chaque structure semiconductrice, ladite région conductrice enterrée étant reliée à un du au moins un premier segment conducteur et un du au moins un deuxième segment conducteur, une région isolante étant positionnée entre la première face de la structure semiconductrice et la région conductrice enterrée.

En d'autres termes, chaque structure semiconductrice comprend une région conductrice enterrée en profondeur et une région isolante positionnée entre la première face de la structure semiconductrice et la région conductrice enterrée, et la première ligne conductrice comprend le au moins un premier segment conducteur et le au moins un deuxième segment conducteur de la structure d'interconnexion, et la région conductrice enterrée de chaque structure semiconductrice. La région conductrice enterrée est à une distance non nulle de la première face de la structure semiconductrice.

Le dispositif de détection de fissure ne comprend pas nécessairement la structure d'interconnexion, mais il comprend la première ligne conductrice qui est formée en partie dans la structure d'interconnexion.

Selon un mode de réalisation, le substrat semiconducteur est dopé d'un premier type de conductivité, la région conductrice enterrée étant une région semiconductrice dopée d'un deuxième type de conductivité opposé au premier type de conductivité.

Selon un mode de réalisation, chaque structure semiconductrice comprend :
- un caisson semiconducteur dopé du deuxième type de conductivité, et s'étendant en profondeur depuis la première face de la structure semiconductrice de manière à relier électriquement ladite première face et la région conductrice enterrée ;
- des éléments conducteurs reliés à la première face de la structure semiconductrice, les éléments conducteurs comprenant un premier élément conducteur reliant le caisson semiconducteur au premier segment conducteur, et un deuxième élément conducteur reliant le caisson semiconducteur au deuxième segment conducteur.

Par exemple, la région isolante est entourée par le caisson semiconducteur.

Selon un mode de réalisation, la région conductrice enterrée est à une profondeur supérieure à 0,5 µm, par exemple supérieure ou égale à 1 µm, ou supérieure ou égale à 3 µm, ou encore supérieure ou égale à 5 µm.

Selon un mode de réalisation, chaque premier segment conducteur est inclus dans un premier empilement métallique comprenant plusieurs niveaux de métallisation de la structure d'interconnexion, et chaque deuxième segment conducteur est inclus dans un deuxième empilement métallique comprenant plusieurs niveaux de métallisation de la structure d'interconnexion.

Selon un mode de réalisation, la au moins une structure semiconductrice comprend plusieurs structures semiconductrices, le au moins un premier segment conducteur comprenant plusieurs premiers segments conducteurs et le au moins un deuxième segment conducteur comprenant plusieurs deuxièmes segments conducteurs, les deuxièmes segments conducteurs entre deux structures semiconductrices adjacentes parmi les structures semiconductrices étant reliés entre eux dans la structure d'interconnexion.

Selon un mode de réalisation, les deuxièmes segments conducteurs sont reliés entre eux au premier niveau de métallisation de la structure d'interconnexion.

Selon un mode de réalisation, les deuxièmes empilements métalliques entre les deux structures semiconductrices adjacentes sont reliés entre eux par un troisième segment conducteur d'un niveau de métallisation de la structure d'interconnexion supérieur au premier niveau de métallisation.

Selon un mode de réalisation, la première ligne conductrice est également adaptée à détecter une fissure dans la structure d'interconnexion.

Selon un mode de réalisation, le dispositif comprend en outre une deuxième ligne conductrice pour détecter une fissure dans la structure d'interconnexion, ladite deuxième ligne conductrice étant comprise dans la structure d'interconnexion et étant distincte de la première ligne conductrice.

Selon un mode de réalisation, la deuxième ligne conductrice comprend :
- au moins un quatrième segment conducteur du premier niveau de métallisation de la structure d'interconnexion, chaque quatrième segment conducteur étant isolé des au moins un premier et au moins un deuxième segments conducteurs par la couche isolante ;
- au moins un cinquième segment conducteur d'un niveau de métallisation de la structure d'interconnexion supérieur au premier niveau de métallisation ;
- au moins un sixième segment conducteur d'un niveau de métallisation de la structure d'interconnexion supérieur au premier niveau de métallisation ;
chaque quatrième segment conducteur reliant un du au moins un cinquième segment conducteur à un du au moins un sixième segment conducteur, par exemple par l'intermédiaire de vias conducteurs de la structure d'interconnexion.

Selon un mode de réalisation, chaque cinquième segment conducteur est inclus dans un troisième empilement métallique comprenant plusieurs niveaux de métallisation de la structure d'interconnexion à partir du deuxième niveau de métallisation, et/ou chaque sixième segment conducteur est inclus dans un quatrième empilement métallique comprenant plusieurs niveaux de métallisation de la structure d'interconnexion à partir du deuxième niveau de métallisation, par exemple deux quatrièmes empilements métalliques adjacents étant reliés entre eux à un niveau de métallisation supérieur au deuxième niveau de métallisation par un septième segment conducteur.

Selon un mode de réalisation, la deuxième ligne conductrice comprend une première extrémité reliée à une première borne d'un deuxième circuit de détection et une deuxième extrémité reliée à une deuxième borne du deuxième circuit de détection, de manière à mesurer un signal électrique dans ladite deuxième ligne conductrice pour déterminer une présence d'une fissure. Par exemple, la première extrémité et/ou la deuxième extrémité de la deuxième ligne conductrice est reliée à le, ou correspond au, au moins un cinquième segment conducteur.

Selon un mode de réalisation, la première ligne conductrice comprend une première extrémité reliée à une première borne d'un premier circuit de détection et une deuxième extrémité reliée à une deuxième borne du premier circuit de détection, de manière à mesurer un signal électrique dans ladite première ligne conductrice pour déterminer une présence d'une fissure. Par exemple, la première extrémité et/ou la deuxième extrémité de la première ligne conductrice est reliée à le, ou correspond au, au moins un premier segment conducteur.

Selon un mode de réalisation, la deuxième borne du deuxième circuit de détection est isolée électriquement de la deuxième borne du premier circuit de détection, par exemple la première borne du deuxième circuit de détection est reliée électriquement à la première borne du premier circuit de détection.

Selon un mode de réalisation, la couche isolante comprend un matériau à constante diélectrique faible comparée à la constante diélectrique du dioxyde de silicium.

Un mode de réalisation prévoit une puce électronique comprenant :
- un substrat semiconducteur ;
- au moins une structure semiconductrice située dans, et/ou sur, le substrat semiconducteur ;
- une structure d'interconnexion reliée à une première face de la au moins une structure semiconductrice ; et
- un dispositif de détection de fissure tel que décrit dans ce qui précède.

Selon un mode de réalisation, la au moins une structure semiconductrice comprend plusieurs structures semiconductrices, au moins une structure semiconductrice parmi lesdites structures semiconductrices comprenant une structure de grille verticale d'un transistor de sélection enterré d'une cellule de mémoire intégrée à transistor de sélection en tranchée.

Selon un mode de réalisation, le dispositif de détection de fissure est positionné en périphérie de la puce électronique, par exemple autour d'une région de circuits électroniques de la puce électronique, par exemple dans un anneau de scellement de la puce électronique.

Un mode de réalisation prévoit un procédé d'utilisation du dispositif de détection de fissure tel que décrit dans ce qui précède, le procédé comprenant :
- l'émission d'un premier signal électrique à une première extrémité de la première ligne conductrice ;
- la réception du premier signal électrique à une deuxième extrémité de la première ligne conductrice, et la mesure d'une première valeur de résistance du premier signal électrique reçu ;
- la comparaison de la première valeur de résistance mesurée avec une première limite basse de résistance pour déterminer une présence d'une fissure dans la première ligne conductrice.

Selon un mode de réalisation, le procédé comprend :
- l'émission d'un deuxième signal électrique à une première extrémité de la deuxième ligne conductrice ;
- la réception du deuxième signal électrique à une deuxième extrémité de la deuxième ligne conductrice, et la mesure d'une deuxième valeur de résistance du deuxième signal électrique reçu ;
- la comparaison de la deuxième valeur de résistance mesurée avec une deuxième limite basse de résistance pour déterminer une présence d'une fissure dans la deuxième ligne conductrice ;
la première limite basse de résistance étant par exemple supérieure à la deuxième limite basse de résistance.

Un mode de réalisation prévoit un procédé de co-intégration de plusieurs structures semiconductrices dans, et/ou sur, un même substrat semiconducteur, le procédé comprenant en outre la formation d'une structure d'interconnexion reliée à une première face des structures semiconductrices, et d'un dispositif de détection de fissure tel que décrit dans ce qui précède, au moins une structure semiconductrice parmi les structures semiconductrices comprenant une structure de grille verticale d'un transistor de sélection enterré d'une cellule de mémoire intégrée à transistor de sélection en tranchée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue de dessus schématique et partielle illustrant un exemple de puce électronique comprenant un détecteur de fissure ;
la figure 1B est une vue en coupe schématique et partielle de la puce électronique de la figure 1A ;
la figure 1C est une autre vue en coupe schématique et partielle de la puce électronique de la figure 1A ;
la figure 2 est une vue en coupe schématique et partielle illustrant un dispositif de détection de fissure selon un mode de réalisation ;
la figure 3 est une vue en coupe schématique et partielle illustrant un dispositif de détection de fissure selon un autre mode de réalisation ;
la figure 4 est une vue en coupe schématique et partielle illustrant un dispositif de détection de fissure selon un autre mode de réalisation ;
la figure 5 est une vue en coupe schématique et partielle illustrant un dispositif de détection de fissure selon un autre mode de réalisation
la figure 6 est une vue en coupe schématique et partielle illustrant un dispositif de détection de fissure selon un autre mode de réalisation ; et
la figure 7 est une vue en coupe schématique et partielle illustrant un dispositif de détection de fissure selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, toutes les étapes de fabrication et les détails des structures semiconductrices ne sont pas décrits, étant réalisables avec les procédés usuels de fabrication de structures semiconductrices dans et/ou sur un substrat semiconducteur. En outre, les étapes de fabrication et les détails des structures d'interconnexion ne sont pas décrits, étant réalisables avec les procédés usuels de fabrication de structures d'interconnexion.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Dans la description qui suit, les termes "isolant" et "conducteur" signifient respectivement, sauf précision contraire, électriquement isolant et électriquement conducteur. Similairement, le terme "isoler" signifie, sauf précision contraire, isoler électriquement.

Dans la description qui suit, sauf précision contraire, lorsque l'on fait référence à une puce, il est fait référence à une puce électronique, lorsque l'on fait référence à un via, il est fait référence à un via conducteur, lorsqu'il est fait référence à un substrat, il est fait référence à un substrat semiconducteur et lorsqu'il est fait référence à un caisson, il est fait référence à un caisson semiconducteur.

Dans la description qui suit, lorsque l'on fait référence à un dispositif de détection de fissure, ou par raccourci à un détecteur de fissure, il est fait référence à un dispositif capable de détecter un défaut structurel qui ne se limite pas à une fissure, par exemple il peut s'agir d'une brèche ou d'une délamination. Par souci de concision, lorsque l'on fait référence à une fissure, cela peut inclure une brèche, une délamination, ou tout autre défaut de structure similaire.

Dans la description qui suit, par "enterré", on entend enterré en profondeur dans la structure semiconductrice.

Dans la description qui suit, un premier niveau de métallisation d'une structure d'interconnexion correspond généralement à un niveau de métallisation le plus proche d'un substrat semiconducteur auquel la structure d'interconnexion est reliée. Un deuxième niveau de métallisation de la structure d'interconnexion correspond à un niveau de métallisation plus éloigné du substrat semiconducteur que le premier niveau de métallisation. Plus généralement, un niveau de métallisation N+1 correspond à un niveau de métallisation plus éloigné du substrat semiconducteur que le niveau de métallisation N.

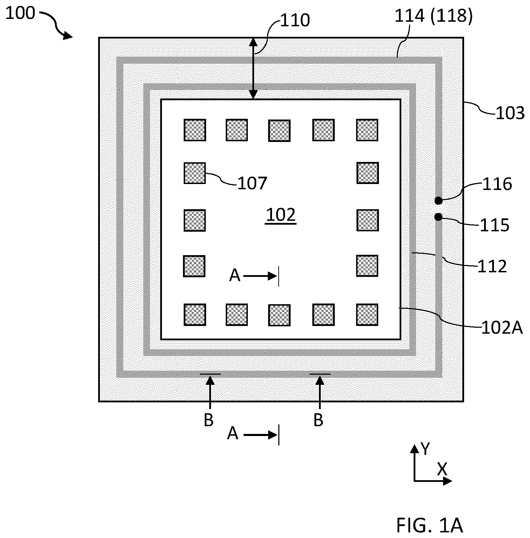

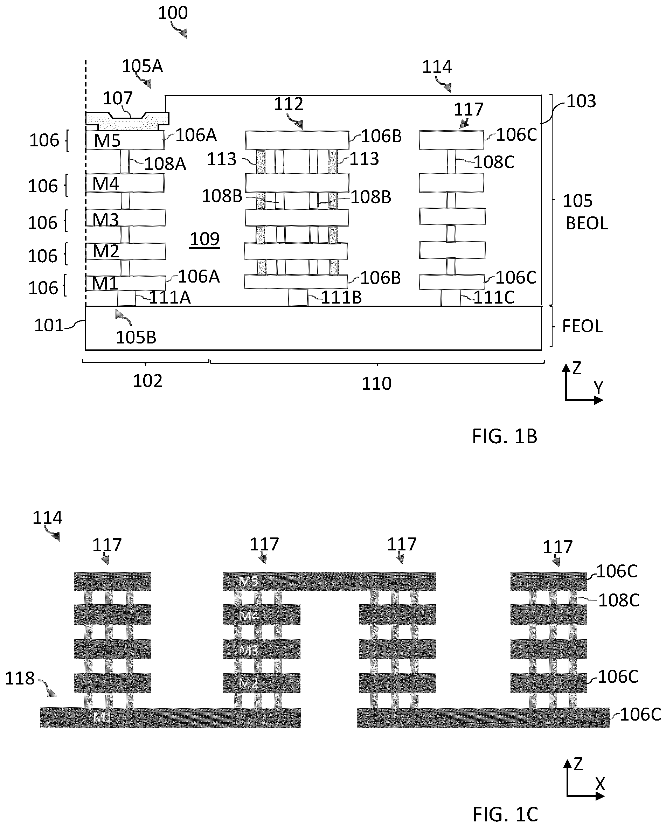

La figure 1A est une vue de dessus schématique et partielle illustrant un exemple de puce électronique 100. La figure 1B est une vue en coupe schématique et partielle de la puce électronique 100 de la figure 1A. La figure 1C est une autre vue en coupe schématique et partielle de la puce électronique de la figure 1A. La figure 1C montre un détail d'un détecteur de fissure intégré dans la puce électronique. La vue en coupe de la figure 1B est réalisée selon le plan de coupe A-A repéré dans la figure 1A. La vue en coupe de la figure 1C est réalisée selon le plan de coupe B-B repéré dans la figure 1A.

La puce électronique 100 comprend une couche semiconductrice 101, qui peut correspondre par exemple à un substrat semiconducteur, par exemple constitué de silicium, ou à la couche semiconductrice d'un substrat du type silicium sur isolant, ou "SOI", de l'anglais "Silicon On Insulator". La couche semiconductrice 101 peut inclure un ou plusieurs caissons dopés.

Des circuits électroniques de la puce 100 sont disposés dans et/ou sur la couche semiconductrice 101, cette partie de la puce étant généralement désignée par "FEOL", pour "front end of line", fin de ligne avant. Par souci de clarté, les circuits électroniques de la puce 100 ne sont pas représentés dans les figures 1A, 1B et 1C, mais sont tous disposés dans une région de circuits électroniques, ou région de circuits 102, de la puce 100 délimitée par une circonférence 102A. En d'autres termes, la région de circuits 102 comprend tous les circuits électroniques de la puce 100. La région de circuits 102 de la puce 100 est, par exemple, une région centrale de la puce 100, comme représenté dans la vue de la figure 1A.

La puce 100 comprend en outre une structure d'interconnexion 105 au-dessus de la couche semiconductrice 101, par exemple en contact avec, ou reliée à, la couche semiconductrice 101. Cette structure d'interconnexion 105 est généralement désignée par structure d'interconnexion "BEOL", de l'anglais "back end of line", structure d'interconnexion de fin de ligne. La structure d'interconnexion 105 comprend une pluralité de niveaux de métallisation. On a représenté cinq niveaux de métallisation M1, M2, M3, M4, M5 dans les figures 1B et 1C, bien que ceci ne soit pas limitatif, le nombre de niveaux de métallisation être inférieur ou supérieur à cinq.

Chaque niveau de métallisation comprend au moins un premier segment 106A d'une couche conductrice 106, par exemple une couche métallique, chaque premier segment 106A formant une piste conductrice. Les pistes conductrices 106A des différents niveaux de métallisation de la structure d'interconnexion 105 sont reliées électriquement entre elles et/ou à des plots de connexion 107 et/ou aux circuits électroniques de la puce 100 par des vias conducteurs 108A, par exemple des vias métalliques. Les pistes conductrices 106A des différents niveaux de métallisation de la structure d'interconnexion 105 sont de préférence positionnées dans la région de circuits 102. Ainsi, la structure d'interconnexion 105 permet de relier les circuits électroniques de la puce 100 entre eux et/ou aux plots de connexion 107. Les plots de connexion 107, qui peuvent être désignés "plots" par raccourci, font partie de la structure d'interconnexion 105. Les plots 107 sont disposés au niveau de métallisation supérieur de la structure d'interconnexion 105 dans l'exemple de la figure 1B, ou dernier niveau de métallisation, qui correspond au niveau de métallisation M5 dans cet exemple. En d'autres termes, les plots 107 sont disposés à une face supérieure 105A (première face) de la structure d'interconnexion 105, une face inférieure 105B (deuxième face) de la structure d'interconnexion, à l'opposé de la première face 105A, étant en reliée à, ou en contact avec, la couche semiconductrice 101.

Les plots 107 peuvent être répartis de manière sensiblement annulaire, ici un anneau de forme carrée, dans la région de circuits 102 de la puce 100 et, plus précisément, dans une région de la structure d'interconnexion 105 comprise dans la région de circuits 102 de la puce 100. D'autres arrangements peuvent être envisagés par une personne du métier.

La structure d'interconnexion 105 comprend en outre une couche isolante 109, qui est généralement un empilement de plusieurs couches isolantes, séparant les différents niveaux de métallisation, les couches conductrices 106 et les vias conducteurs étant noyés dans la couche isolante 109. La couche isolante 109 peut être en un oxyde, par exemple un oxyde de silicium.

La piste conductrice 106A au premier niveau de métallisation M1 de la structure d'interconnexion 105 peut être reliée à la couche semiconductrice 101 par un via conducteur ou par un contact 111A, ou tout autre élément de connexion électrique.

La puce 100 comprend une région de scellement 110, ou anneau de scellement, connu sous le terme de "seal-ring" en anglais, en périphérie de la puce 100, c'est à dire entre la région de circuits 102 et le bord 103 de la puce 100. Ainsi, l'anneau de scellement 110 entoure la région de circuits 102 de la puce 100. L'anneau de scellement 110 présente une forme annulaire en vue de dessus. L'anneau de scellement 110 est disposé dans la structure d'interconnexion 105, au niveau de la périphérie de la puce 100. L'anneau de scellement 110 fait ainsi partie de la structure d'interconnexion 105 bien qu'il ne soit pas utilisé pour connecter ensemble les circuits électroniques de la puce 100 entre eux et/ou avec les plots 107. De préférence, la puce 100 ne comprend aucun circuit électronique dans l'anneau de scellement 110. En d'autres termes, la région de circuits 102 de la puce 100 est délimitée latéralement, dans la structure d'interconnexion 105, par l'anneau de scellement 110.

Une fonction visée de l'anneau de scellement 110 est d'éviter la propagation de fissures depuis le bord 103 de la puce 100 jusqu'à la région de circuits 102 de la puce 100. Une autre fonction visée de l'anneau de scellement 110 peut être de bloquer la propagation de l'humidité depuis l'extérieur de la puce 100, donc depuis le bord 103 de la puce 100, jusqu'aux circuits électroniques de la région de circuits 102 de la puce 100. Une autre fonction visée de l'anneau de scellement 110 peut être de détecter une fissure dans la puce électronique 100.

Pour remplir une ou plusieurs de ces fonctions, l'anneau de scellement 110 peut inclure un ou plusieurs éléments de scellement 112, chaque élément de scellement présentant une forme annulaire en vue de dessus. On a représenté un élément de scellement dans les figures 1A, 1B et 1C, bien qu'il puisse y en avoir plusieurs. Lorsqu'il y a plusieurs éléments de scellement, ils peuvent être sensiblement concentriques. Un élément de scellement peut être adapté à stopper la propagation de fissures, un autre élément de scellement peut être adapté à bloquer l'entrée d'humidité, et/ou un élément de scellement peut être adapté à remplir ces deux fonctions d'arrêt de propagation de fissures et de blocage de l'entrée d'humidité.

L'élément de scellement 112 s'étend en hauteur depuis le premier niveau de métallisation M1, au-dessus de la couche semiconductrice 101, jusqu'au niveau de métallisation supérieur, le niveau M5 dans l'exemple représenté, bien que le niveau de métallisation supérieur puisse être différent de M5, par exemple M6, M7 ou plus, voire M4 ou moins.

L'élément de scellement 112 représenté forme une boucle fermée autour de la région de circuits 102 de la puce 100. En d'autres termes, l'élément de scellement 112 entoure complétement la région de circuits 102 de la puce 100.

Dans l'exemple de réalisation représenté en figure 1B, l'élément de scellement 112 comprend des deuxièmes segments 106B des couches conductrices 106 de la structure d'interconnexion 105. Plus précisément, l'élément de scellement 112 comprend au moins un deuxième segment 106B de la couche conductrice 106 de chaque niveau de métallisation M1-M5 de la structure d'interconnexion 105. Les deuxièmes segments 106B des différents niveaux de métallisation sont noyés dans la couche isolante 109. Chaque deuxième segment 106B de la couche conductrice 106 forme une plaque conductrice annulaire à chaque niveau de métallisation. Par exemple, chaque plaque conductrice annulaire 106B s'étend dans un plan sensiblement parallèle à la couche semiconductrice 101.

Les plaques conductrices annulaires 106B successives de l'élément de scellement 112 sont reliées verticalement entre elles par un ou plusieurs éléments conducteurs, par exemple :
- des vias conducteurs 108B de la structure d'interconnexion 105 : les vias peuvent être sous forme cylindrique ou être allongés sous forme de barres ou de lignes ; et/ou
- des bandes conductrices annulaires 113 qui s'étendent en continu entre deux plaques conductrices annulaires 106B successives : en d'autres termes, les bandes conductrices annulaires 113 joignent deux plaques conductrices annulaires 106B successives dans la direction Z perpendiculaire au plan XY de la couche semiconductrice 101.

L'élément de scellement 112 peut être relié à la couche semiconductrice 101 via la plaque conductrice 106B du premier niveau de métallisation M1 par un via conducteur ou un contact 111B, ou tout autre élément conducteur électrique.

Afin de détecter des fissures dans la puce 100, l'anneau de scellement 110 inclut un détecteur de fissure 114. Le détecteur de fissure 114 est ainsi positionné en périphérie de la puce 100, autour de la région de circuits 102.

Le détecteur de fissure 114 est disposé dans la structure d'interconnexion 105. En d'autres termes, la structure d'interconnexion 105 inclut le détecteur de fissure 114. Le détecteur de fissure 114 s'étend en hauteur depuis le premier niveau de métallisation M1, au-dessus de la couche semiconductrice 101, jusqu'au niveau de métallisation supérieur M5.

Comme représenté en figure 1A, le détecteur de fissure 114 peut être disposé dans une région comprise entre le bord 103 de la puce 100 et l'élément de scellement 112. Ainsi, si une fissure apparaît au niveau du bord 103 de la puce 100 et se propage vers la région de circuits 102, la fissure peut être détectée par le détecteur de fissure 114 avant l'élément de scellement 112. D'autres configurations peuvent être envisagées par une personne du métier, avec un ou plusieurs éléments de scellement et/ou un ou plusieurs détecteurs de fissure, comme décrit plus après. De préférence, le détecteur de fissure détecte une fissure avant qu'elle n'atteigne la région de circuits 102 de la puce 100.

Le détecteur de fissure 114 comprend une structure conductrice 118, ou une ligne conductrice, qui forme de préférence une boucle ouverte. En mesurant un paramètre électrique, par exemple une conductivité ou une résistance électrique, entre une première borne, ou nœud, 115 de la ligne conductrice 118 et une deuxième borne, ou nœud, 116 de la ligne conductrice 118, des fissures peuvent être détectées par le détecteur de fissure 114. Le détecteur de fissure 114 peut comprendre un circuit de détection (non représenté), qui peut être relié aux première et deuxième bornes 115, 116, pour détecter un changement d'un paramètre électrique dans la ligne conductrice 118 indiquant la présence d'une fissure. Le circuit de détection peut être implémenté dans la puce électronique 100, par exemple dans la région de circuits 102, ou dans un circuit extérieur à la puce électronique 100.

Dans l'exemple de réalisation représenté en figures 1B et 1C, la ligne conductrice 118 est construite dans la structure d'interconnexion 105, et elle comprend plusieurs empilements métalliques 117, chaque empilement métallique incluant des troisièmes segments 106C des couches conductrices 106 de la structure d'interconnexion 105 et des vias conducteurs 108C entre les troisièmes segments 106C des différents niveaux de métallisation. Les troisièmes segments 106C des différents niveaux de métallisation sont noyés dans la couche isolante 109.

Deux empilements métalliques 117 adjacents sont reliés entre eux par un ou plusieurs troisièmes segments 106C d'un des niveaux de métallisation. Dans l'exemple représenté en figure 1C, les empilements métalliques 117 adjacents sont reliés entre eux par des troisièmes segments 106C du premier niveau de métallisation M1 ou par des troisièmes segments 106C du dernier niveau de métallisation M5. On a illustré à titre d'exemple en figure 1C quatre empilements métalliques 117 du détecteur de fissure 116, mais le détecteur de fissures 114 peut en comprendre davantage, par exemple pour faire le tour de la puce électronique 100.

Le détecteur de fissure 114 peut être relié à la couche semiconductrice 101 via le troisième segment 106C du premier niveau de métallisation M1 par un via conducteur ou un contact 111C, ou tout autre élément conducteur électrique.

Bien que cela ne soit pas représenté dans les figures 1A, 1B et 1C, l'anneau de scellement 110 peut comprendre plusieurs éléments de scellement similaires à l'élément de scellement 112 décrit précédemment, par exemple un élément de scellement interne disposé dans la structure d'interconnexion 105 autour de la région de circuits 102 et un élément de scellement externe disposé dans la structure d'interconnexion 105 autour de l'élément de scellement interne. L'anneau de scellement 110 peut alors comprendre un détecteur de fissure intermédiaire, par exemple similaire au détecteur de fissure 114 décrit précédemment, disposé dans la structure d'interconnexion 105 entre l'élément de scellement interne et l'élément de scellement externe. La présence d'éléments de scellement interne et externe et d'un détecteur de fissure intermédiaire entre ces deux éléments de scellement permet de détecter que des fissures se sont propagées depuis le bord 103 de la puce électronique à travers l'élément de scellement externe. L'anneau de scellement 110 peut comprendre un détecteur de fissure interne disposé dans la structure d'interconnexion 105 autour de, ou sur les bords de, la région de circuits 102 et entouré par l'élément de scellement 112, ou l'élément de scellement interne. Un tel détecteur de fissure interne permet de détecter que des fissures se sont propagées depuis le bord 103 de la puce 100 à travers le (ou les) élément(x) de scellement et peuvent atteindre la région de circuits 102.

Les détecteurs de fissure connus, tels que ceux décrits dans ce qui précède, permettent de détecter une fissure à partir du premier niveau de métallisation M1 jusqu'à un ou plusieurs niveaux de métallisation plus élevé(s). Les détecteurs de fissure connus ne permettent pas de détecter une fissure en dessous du premier niveau de métallisation M1, en particulier ne permettent pas de détecter une fissure dans la couche semiconductrice, ou le substrat semiconducteur, sous la structure d'interconnexion.

Les inventeurs proposent un dispositif de détection de fissure dans une structure semiconductrice permettant de répondre aux besoins d'amélioration décrits précédemment, et de pallier tout ou partie des inconvénients des détecteurs de fissures décrits précédemment.

En particulier, les inventeurs proposent un dispositif de détection de fissure permettant de détecter une fissure dans le substrat semiconducteur, en-dessous de la structure d'interconnexion, c'est-à-dire dans la partie dite FEOL, ou dans une structure semiconductrice formée dans et/ou sur le substrat semiconducteur.

Il serait avantageux que le dispositif de détection de fissure puisse également détecter une fissure dans la structure d'interconnexion, c'est-à-dire dans la partie BEOL. En particulier, il serait avantageux que le dispositif de détection de fissure puisse distinguer une fissure dans la structure d'interconnexion (partie BEOL) d'une fissure dans le substrat semiconducteur (partie FEOL).

Des modes de réalisation de dispositifs de détection de fissure vont être décrits ci-après. Les modes de réalisation décrits sont non limitatifs et diverses variantes apparaîtront à la personne du métier à partir des indications de la présente description.

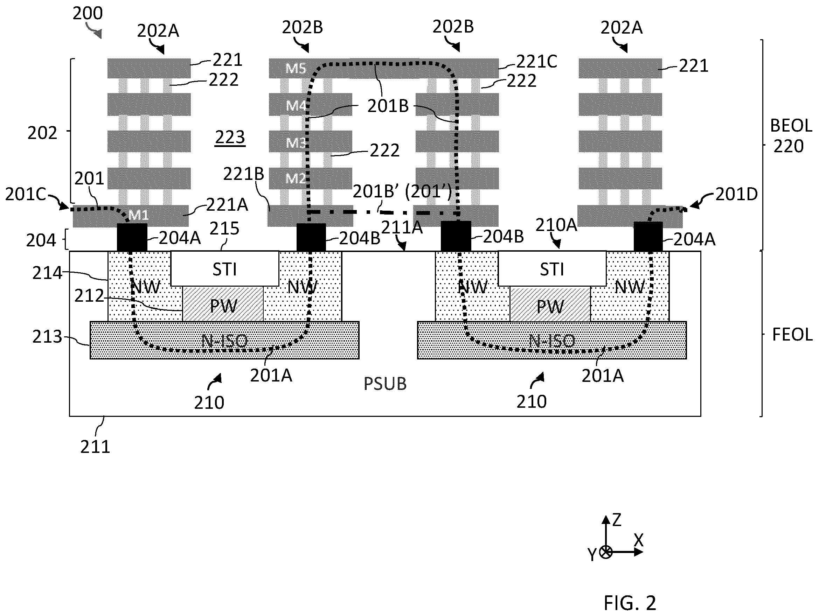

Les figures 2 à 7 décrites dans ce qui suit décrivent des exemples de structures semiconductrices de type CMOS, de l'anglais "complementary metal-oxide-semiconductor", formées dans, et/ou sur, un substrat semiconducteur : par exemple une structure du type "triple well", ou triple caisson, une structure à grille verticale avec implant sous la grille, par exemple pour former un transistor en tranchée. Ces exemples de structures semiconductrices ne sont pas limitatifs, d'autres structures semiconductrices de type CMOS pouvant être envisageables par une personne du métier. En outre, plusieurs structures semiconductrices différentes peuvent être formées dans et/ou sur le substrat semiconducteur.

Dans les figures 2 à 7 décrites dans ce qui suit, le substrat semiconducteur est typiquement un substrat de silicium dopé de type P. En d'autres termes, le premier type de dopage, ou type de conductivité, est de type P. En variante, le substrat semiconducteur pourrait être dopé de type N, c'est-à-dire le premier type de dopage, ou type de conductivité, pourrait être de type N, auquel cas la personne du métier saura adapter le type de dopage des caissons semiconducteurs, régions et couches semiconductrices dans les dispositifs, structures et procédés décrits dans ce qui suit. Le substrat semiconducteur pourrait être en un autre matériau que du silicium.

Les dispositifs de détection des figures 2 à 7 sont de préférence intégrés dans une puce électronique, par exemple une puce électronique similaire à celle des figures 1A et 1B. Les dispositifs de détection des figures 2 à 7 peuvent alors faire partie d'une structure d'interconnexion de la puce électronique. En particulier, les dispositifs de détection des figures 2 à 7 peuvent être positionnés en périphérie de la puce électronique, autour d'une région de circuits électroniques de la puce. Par exemple, les dispositifs de détection des figures 2 à 7 peuvent être intégrés dans un anneau de scellement, en association avec un ou plusieurs éléments de scellement, de manière similaire à ce qui est décrit en relation avec les figures 1A et 1B. Les différentes variantes d'anneau de scellement décrites en relation avec les figures 1A et 1B peuvent également s'appliquer. De plus, dans les figures 2 à 7, on a représenté cinq niveaux de métallisation M1-M5 dans la structure d'interconnexion, bien qu'il puisse y avoir six niveaux (M1-M6) ou sept niveaux (M1-M7), ou plus, voire moins de cinq niveaux.

Chacun des dispositifs de détection de fissure 200, 300, 400 des figures 2 à 4 se distingue du détecteur de fissure 114 de la figure 1C principalement en ce que la ligne conductrice (première ligne conductrice) du dispositif de détection n'est pas seulement formée dans la structure d'interconnexion, mais elle comprend également une ou plusieurs portions conductrices dans le substrat semiconducteur, ou dans des structures semiconductrices formées dans et/ou sur le substrat semiconducteur, ces portions conductrices formant un canal de conduction électrique. En particulier, chacun des dispositifs de détection de fissure des figures 2 à 4 se distingue du détecteur de fissure 114 de la figure 1C en ce que les empilements métalliques ne sont pas reliés entre eux par des segments de la couche conductrice du premier niveau de métallisation M1, mais par les portions conductrices dans le substrat semiconducteur.

Dans chacune des figures 2 à 4, des structures semiconductrices sont formées dans, et/ou sur, le substrat semiconducteur. Il s'agit généralement de structures semiconductrices de type CMOS. La ligne conductrice de chacun des dispositifs de détection de fissure des figures 2 à 4 ne passe pas uniquement dans la structure d'interconnexion, c'est-à-dire ne comprend pas uniquement des segments de couches conductrices de la structure d'interconnexion, mais elle comprend également des portions conductrices dans ces structures semiconductrices.

Différentes structures semiconductrices 210, 310, 410 vont maintenant être décrites dans la description des figures 2 à 4 qui suit, ainsi que différentes lignes conductrices 201, 301, 401 qui dépendent du type de structure semiconductrice. En particulier, la profondeur de la ligne conductrice, et ainsi la profondeur de détection de fissure, peut dépendre du type de structure semiconductrice.

Dans les figures 2 à 4, la ligne conductrice 201, 301, 401 (première ligne conductrice) est symbolisée par une ligne en pointillés qui permet de visualiser un chemin conducteur, parmi plusieurs chemins possibles le long de la ligne conductrice 201, 301, 401. La ligne conductrice 201, 301, 401 n'est donc pas limitée à cette ligne en pointillés.

La figure 2 est une vue en coupe schématique et partielle illustrant un dispositif de détection de fissure 200 selon un mode de réalisation.

Chaque structure semiconductrice 210 de la figure 2 est une structure du type triple caisson, connue sous le terme "triple well" en anglais.

Chaque structure triple caisson 210 permet d'isoler électriquement un caisson semiconducteur 212 (PW) dopé d'un premier type de dopage, qui est le même type de dopage que le substrat semiconducteur 211 (PSUB), dans l'exemple représenté un dopage de type P, au moyen de régions semiconductrices 213, 214 dopées du deuxième type de dopage opposé au premier type de dopage. Dans l'exemple représenté, le deuxième type de dopage est de type N.

Les régions semiconductrices comprennent :
- une région semiconductrice enterrée 213 (N-ISO) dopée du deuxième type de dopage, permettant d'isoler en profondeur le caisson 212 par rapport au substrat semiconducteur 211 ; et
- un caisson semiconducteur annulaire 214 (NW), ou région semiconductrice annulaire, dopé du deuxième type de dopage, entourant latéralement le caisson semiconducteur 212 (selon les directions X et Y), permettant de l'isoler latéralement.

Dans l'ensemble de la description, le terme "annulaire" désigne une forme d'anneau qui n'est pas nécessairement circulaire, mais qui peut être par exemple carrée ou rectangulaire, plus largement une zone géométrique délimitée par un périmètre intérieur et un périmètre extérieur sensiblement parallèles entre eux.

Le caisson semiconducteur annulaire 214 s'étend depuis la face supérieure 211A du substrat semiconducteur 211 en profondeur, de préférence jusqu'à la région semiconductrice enterrée 213. Ainsi, le caisson semiconducteur annulaire 214 est de préférence en contact avec la région semiconductrice enterrée 213.

Dans l'exemple de la figure 2, la face supérieure 210A de la structure semiconductrice 210 correspond à la face supérieure 211A du substrat semiconducteur 211.

En outre, une tranchée isolante 215 (STI), par exemple du type tranchée isolante peu profonde, connue sous le terme STI, pour "Shallow Trench Isolation" en anglais, est localisée au-dessus du caisson semiconducteur 212 et est entourée par le caisson semiconducteur annulaire 214. Ainsi, le caisson semiconducteur 212 est enterré, et il est électriquement isolé en partie supérieure par la tranchée isolante 215. Le caisson semiconducteur 212 est ainsi entièrement entouré de régions qui l'isolent électriquement. La tranchée isolante 215 peut déborder de part et d'autre du caisson semiconducteur 212 dans le caisson semiconducteur annulaire 214.

Un exemple simplifié de procédé de formation d'une structure semiconductrice 210 comprend :
- une gravure à partir de la face supérieure 211A du substrat semiconducteur 211 pour former une tranchée peu profonde dans le substrat semiconducteur 211, puis un remplissage de cette tranchée, par exemple en oxyde de silicium, pour former la tranchée isolante 215 ;
- une implantation en profondeur dans le substrat semiconducteur 211 pour former la région semiconductrice enterrée 213 (N-ISO), cette implantation étant du deuxième type de dopage, dans cet exemple du type N ;
- une implantation à partir de la face supérieure 211A du substrat semiconducteur 211 pour former le caisson semiconducteur annulaire 214 (NW), cette implantation étant du deuxième type de dopage, dans cet exemple du type N ;
- une implantation dans le substrat semiconducteur 211 à travers la tranchée isolante 215 et dans la partie centrale délimitée par le caisson semiconducteur annulaire 214 pour former le caisson semiconducteur 212, cette implantation étant du premier type de dopage, dans cet exemple du type P.

L'ordre des deux dernières étapes peut être inversé.

Le caisson semiconducteur annulaire 214 est implanté de préférence avec une énergie permettant d'atteindre en profondeur la région semiconductrice enterrée 213, de manière à former avec la région semiconductrice enterrée 213 une région semiconductrice de type N continue pour isoler le caisson semiconducteur 212 de type P.

A titre d'exemple, la couche semiconductrice enterrée 213 peut former un plan source, ou une région de source, pour un transistor vertical, et le caisson semiconducteur 212 peut contenir une cellule mémoire.

Dans une telle structure triple caisson, des jonctions PN de polarités opposées au caisson 212 de type P, formées avec les régions semiconductrices 213, 214 de type N, permettent d'isoler électriquement le caisson 212, qui est en outre isolé par la tranchée isolante 215. Le courant est donc conduit à travers la région semiconductrice enterrée 213 via le caisson semiconducteur annulaire 214. Les régions semiconductrices 213, 214 forment ainsi une portion conductrice 201A, ou canal de conduction électrique, dans le substrat semiconducteur 211, dans chaque structure semiconductrice 210.

La portion conductrice 201A de chaque structure semiconductrice 210 correspond à une première portion d'une ligne conductrice 201 (première ligne conductrice) du dispositif de détection 200. La ligne conductrice 201 inclut donc les régions semiconductrices 213, 214 des structures semiconductrices 210, c'est-à-dire la région semiconductrice enterrée 213 et le caisson semiconducteur annulaire 214 de chaque structure semiconductrice 210.

La ligne conductrice 201 comprend en outre tout ou partie de plusieurs empilements métalliques 202. Les empilements métalliques 202 font partie d'une structure d'interconnexion 220 (BEOL) positionnée au-dessus du substrat semiconducteur 211. Chaque empilement métallique 202 comprend des segments conducteurs 221 à chaque niveau de métallisation M1-M5 de la structure d'interconnexion 220 et des vias conducteurs 222 entre les segments conducteurs 221 des différents niveaux de métallisation M1-M5. Un segment conducteur 221 d'un niveau de métallisation correspond généralement à un segment, ou une portion, d'une couche conductrice, par exemple une couche métallique, formée dans ce niveau de métallisation. Les segments conducteurs 221 et les vias conducteurs 222 sont noyés dans une couche isolante 223.

Dans l'exemple représenté, les portions de la ligne conductrice 201 qui sont formées dans les empilements métalliques 202 incluent :
- un segment conducteur 221A (premier segment conducteur) du premier niveau de métallisation M1 pour chacun de deux premiers empilements métalliques 202A ; et
- plusieurs segments conducteurs 221 de plusieurs niveaux de métallisations reliés par des vias conducteurs 222 pour chacun de deux deuxièmes empilements métalliques 202B.

La ligne conductrice 201 comprend en outre des contacts 204. On considère que les contacts 204 font partie de la structure d'interconnexion 220. Les contacts 204 comprennent des premiers contacts 204A reliant chacune des structures semiconductrices 210 au segment conducteur 221A d'un des premiers empilements métalliques 202A, et des deuxièmes contacts 204B reliant chacune des structures semiconductrices 210 à un des deuxièmes empilements métalliques 202B, plus précisément à un segment conducteur 221B (deuxième segment conducteur) d'un des deuxièmes empilements métalliques 202B. Chacune de ces liaisons par contact est réalisée au premier niveau de métallisation M1. Les contacts 204 sont reliés, par exemple connectés, à la face supérieure 210A de la structure semiconductrice 210, qui correspond ici à la face supérieure 211A du substrat semiconducteur 211. En particulier, les contacts 204 sont reliés, par exemple connectés, aux caissons semiconducteurs annulaires 214 des structures semiconductrices 210. Ainsi, chaque caisson semiconducteur annulaire 214 est relié à des premier et deuxième empilements métalliques 202A, 202B par l'intermédiaire des contacts 204. Ainsi, les premier et deuxième empilements métalliques 202A, 202B ne sont pas reliés entre eux par des segments conducteurs au premier niveau de métallisation M1, comme dans la figure 1C, mais par la portion conductrice 201A dans la structure semiconductrice 210, c'est-à-dire la région semiconductrice enterrée 213 et le caisson semiconducteur annulaire 214.

Les deuxièmes empilements métalliques 202B entre les deux structures semiconductrices 210 sont reliés entre eux au dernier niveau de métallisation M5 par un segment conducteur 221C (troisième segment conducteur) qui est continu entre ces deuxièmes empilements métalliques. Ainsi, une deuxième portion 201B de la ligne conductrice 201 inclut tous les niveaux de métallisation M1-M5 des deuxièmes empilements métalliques 202B, c'est-à-dire les segments conducteurs 221 et les vias conducteurs 222 de tous les niveaux de métallisation, incluant le segment conducteur 221C continu entre les deuxièmes empilements métalliques 202B au dernier niveau de métallisation M5.

La ligne conductrice 201 comprend ainsi :
- les premières portions 201A formées par les régions semiconductrices 213, 214 dopées N des structures semiconductrices 210 ;
- la deuxième portion 201B entre les premières portions 201A, la deuxième portion étant formée par les deuxièmes empilements métalliques 202B reliés entre eux par le segment conducteur 221C au dernier niveau de métallisation M5 de la structure d'interconnexion 220, la deuxième portion 201B étant reliée à chacune des premières portions 201A par un des deuxièmes contacts 204B ;
- les segments conducteurs 221A des premiers empilements métalliques 202A reliés chacun à une des premières portions 201A par un des premiers contacts 204A.

La ligne conductrice 201 peut être reliée à un circuit de détection (non représenté). Par exemple, une première extrémité 201C de la ligne conductrice 201 peut être reliée à une première borne du circuit de détection au premier niveau de métallisation M1, et une deuxième extrémité 201D de la ligne conductrice 201 peut être reliée à une deuxième borne du circuit de détection au premier niveau de métallisation M1, mais la liaison peut être réalisée à tout autre niveau de métallisation. Le circuit de détection peut être configuré pour détecter un changement d'un paramètre électrique dans la ligne conductrice 201 indiquant la présence d'une fissure.

Dans l'exemple de la figure 2, une extrémité de chaque segment conducteur 221A peut correspondre à une des première 201C et deuxième 201D extrémités de la ligne conductrice 201.

Un tel dispositif de détection 200 permet de détecter une fissure en profondeur jusqu'à dans une région semiconductrice enterrée du substrat semiconducteur 211, la région semiconductrice enterrée 213 dans l'exemple de la figure 2. Plus largement, le dispositif de détection 200 permet de détecter une fissure le long de la ligne conductrice 201, entre la région semiconductrice enterrée 213 et le niveau de métallisation supérieur M5. Pour détecter une fissure, on peut déterminer un changement de paramètre électrique dans la ligne conductrice 201, par exemple une augmentation de résistance lorsque la ligne conductrice 201 est détériorée par une fissure dans une des régions semiconductrices 213, 214, voire une résistance infinie lorsque la ligne conductrice 201 est interrompue. Une limite basse de résistance peut être définie pour déterminer si une fissure s'est produite.

La région semiconductrice enterrée 213 peut être située à une profondeur allant jusqu'à 3 µm, voire jusqu'à 5 µm dans le substrat semiconducteur 211. Ainsi, le dispositif de détection 200 peut détecter une fissure jusqu'à une profondeur de 5 µm.

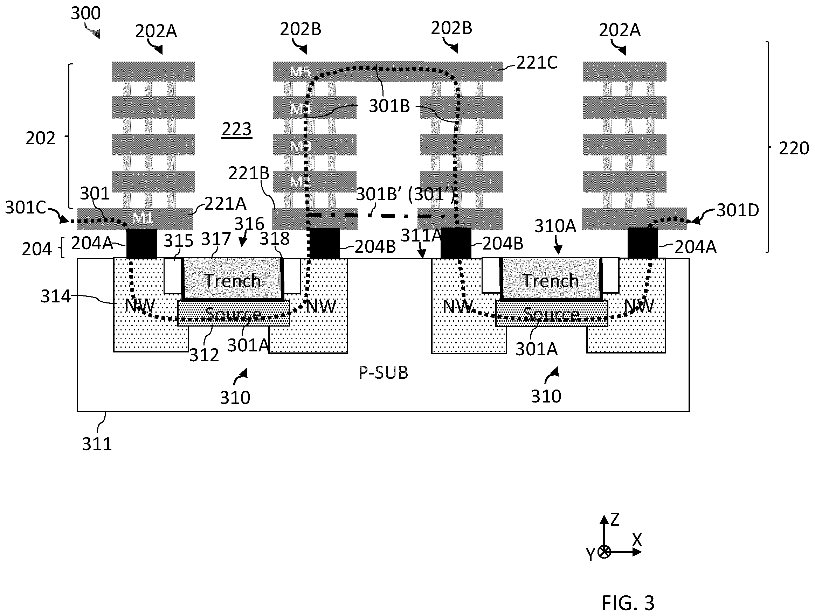

La figure 3 est une vue en coupe schématique et partielle illustrant un dispositif de détection de fissure 300 selon un autre mode de réalisation.

Le dispositif de détection de fissure 300 de la figure 3 a de nombreux éléments en commun avec le dispositif de détection de fissure 200 de la figure 2 et seules les différences entre les deux dispositifs de détection de fissure sont détaillées dans la description qui suit.

Le dispositif de détection de fissure 300 de la figure 3 se distingue du dispositif de détection de fissure 200 de la figure 2 principalement par les structures semiconductrices 310 qui sont du type structure à grille verticale, avec une région d'implantation enterrée sous la grille.

Chaque structure semiconductrice 310 comprend une structure de grille verticale 316 qui s'étend en profondeur dans le substrat semiconducteur 311, depuis la face supérieure 311A du substrat semiconducteur 311.

Dans l'exemple de la figure 3, la face supérieure 310A de la structure semiconductrice 310 correspond à la face supérieure 311A du substrat semiconducteur 311.

La structure de grille verticale 316 comprend une tranchée conductrice 317 (Trench), c'est-à-dire une tranchée remplie d'un matériau conducteur, par exemple du silicium polycristallin (polysilicium), le fond et les flancs de la tranchée étant isolés par une couche isolante 318, par exemple d'oxyde de silicium.

La tranchée conductrice 317 est entourée au moins partiellement par une tranchée isolante 315, par exemple du type tranchée isolante peu profonde, par exemple du même type que la tranchée isolante 215 de la figure 2.

La structure semiconductrice 310 comprend en outre une région semiconductrice enterrée 312 (Source) dopée du deuxième type de dopage, c'est-à-dire opposé au type de dopage du substrat semiconducteur 311. Dans l'exemple représenté, le substrat semiconducteur 311 est dopé du type P et la région semiconductrice enterrée 312 est dopée du type N. La région semiconductrice enterrée 312 s'étend en profondeur depuis le fond de la structure de grille 316. En variante, cette région semiconductrice enterrée 312 pourrait être localisée autour et en dessous de la structure de grille 316.

La tranchée isolante 315 (STI), la tranchée conductrice 317 et la région semiconductrice enterrée 312 sont entourées latéralement (selon les directions X et Y) par un caisson semiconducteur annulaire 314 (NW) dopé du deuxième type de dopage, dans l'exemple représenté du type N.

Un exemple simplifié de procédé de formation d'une structure semiconductrice 310 comprend :
- une gravure à partir de la face supérieure 311A du substrat semiconducteur 311 pour former une tranchée peu profonde dans le substrat semiconducteur 311, puis un remplissage de cette tranchée, par exemple en oxyde de silicium, pour former la tranchée isolante 315 ;
- une gravure à travers la tranchée isolante 315 à partir de la face supérieure 311A du substrat semiconducteur 311 pour former une tranchée destinée à être remplie en un matériau conducteur pour former la future tranchée conductrice 317 ;
- une implantation en profondeur dans le substrat semiconducteur 311 sous la tranchée pour former la région semiconductrice enterrée 312, cette implantation étant du deuxième type de dopage, dans l'exemple du type N ;
- une implantation à partir de la face supérieure 311A du substrat semiconducteur 311 pour former le caisson semiconducteur annulaire 314 autour de la tranchée isolante 315 et de la région semiconductrice enterrée 312, cette implantation étant du deuxième type de dopage, dans l'exemple du type N ;
- une formation d'une couche isolante 318 sur le fond et les flancs de la tranchée, puis un remplissage en le matériau conducteur, par exemple en polysilicium, de la tranchée recouverte par la couche isolante 318 pour former la tranchée conductrice 317.

L'ordre des deux dernières étapes peut être inversé.

Dans chaque structure semiconducteur 310, le courant est conduit à travers la région semiconductrice enterrée 312 via le caisson semiconducteur annulaire 314, la tranchée conductrice 317 étant isolée par la couche isolante 318. Ainsi, les régions semiconductrices 312, 314 forment une portion conductrice 301A dans le substrat semiconducteur 311, dans chaque structure semiconductrice 310, cette portion conductrice 301A formant une première portion d'une ligne conductrice 301.

Ce type de structure de grille verticale peut correspondre à une structure de grille verticale d'un transistor enterré, utilisé par exemple comme transistor de sélection, ou d'accès, d'une cellule mémoire, par exemple pour une mémoire de type eSTM, de l'anglais "embedded Select in-Trench Memory", mémoire intégrée à transistor de sélection en tranchée.

Les autres caractéristiques et variantes décrites en relation avec la figure 2, par exemple les empilements métalliques 202, les contacts 204, la deuxième portion 201B de la ligne conductrice, peuvent s'appliquer au mode de réalisation de la figure 3. En particulier, similairement au mode de réalisation de la figure 2, la ligne conductrice 301 comprend en outre tout ou partie d'empilements métalliques 202 faisant partie d'une structure d'interconnexion 220 (BEOL) positionnée au-dessus du substrat semiconducteur 311. En outre, similairement au mode de réalisation de la figure 2, un premier contact 204A et un deuxième contact 204B, positionnés sur les caissons semiconducteurs annulaires 314 des structures semiconductrices 310 permettent de relier chacune des structures semiconductrices 310 à respectivement un premier empilement métallique 202A et un deuxième empilement métallique 202B, les deuxièmes empilements métalliques 202B entre les deux structures semiconductrices 310 étant reliés entre eux au dernier niveau de métallisation M5, ou à tout autre niveau de métallisation.

La ligne conductrice 301 comprend :
- les portions conductrices 301A, ou premières portions, formées par les régions semiconductrices 312, 314 dopées N des structures semiconductrices 310 ;
- une deuxième portion 301B entre les premières portions 301A, la deuxième portion étant similaire à la deuxième portion 201B décrite en relation avec la figure 2, la deuxième portion 301B étant reliée à chacune des premières portions 301A par un des deuxièmes contacts 204B ; et
- les segments conducteurs 221A des premiers empilements métalliques 202A reliés chacun à une des premières portions 301A par un des premiers contacts 204A.

Similairement à ce qui est décrit en relation avec la figure 2, la ligne conductrice 301 peut être reliée à un circuit de détection (non représenté). Par exemple, une première extrémité 301C de la ligne conductrice 301 peut être reliée à une première borne du circuit de détection au premier niveau de métallisation M1, et une deuxième extrémité 301D de la ligne conductrice 301 peut être reliée à une deuxième borne du circuit de détection au premier niveau de métallisation M1, mais la liaison peut être réalisée à tout autre niveau de métallisation. Le circuit de détection peut être configuré pour détecter un changement d'un paramètre électrique dans la ligne conductrice 301 indiquant la présence d'une fissure. Une extrémité de chaque segment conducteur 221A peut correspondre à une des première 301C et deuxième 301D extrémités de la ligne conductrice 301.

Un tel dispositif de détection 300 permet de détecter une fissure en profondeur jusqu'à dans une région semiconductrice enterrée du substrat semiconducteur 311, la région semiconductrice enterrée 312 dans l'exemple de la figure 3. Plus largement, le dispositif de détection 300 permet de détecter une fissure le long de la ligne conductrice 301, entre la région semiconductrice enterrée 312 et le niveau de métallisation supérieur M5. Pour détecter une fissure, on peut déterminer un changement de paramètre électrique dans la ligne conductrice 301, par exemple une augmentation de résistance lorsque la ligne conductrice 301 est détériorée par une fissure dans une des régions semiconductrices 312, 314, voire une résistance infinie lorsque la ligne conductrice 301 est interrompue. Une limite basse de résistance peut être définie pour déterminer si une fissure s'est produite.

La région semiconductrice enterrée 312 peut être située à une profondeur allant jusqu'à 0,5 µm, voire jusqu'à 1 µm. Ainsi, le dispositif de détection 300 peut détecter une fissure jusqu'à une profondeur de 1 µm.

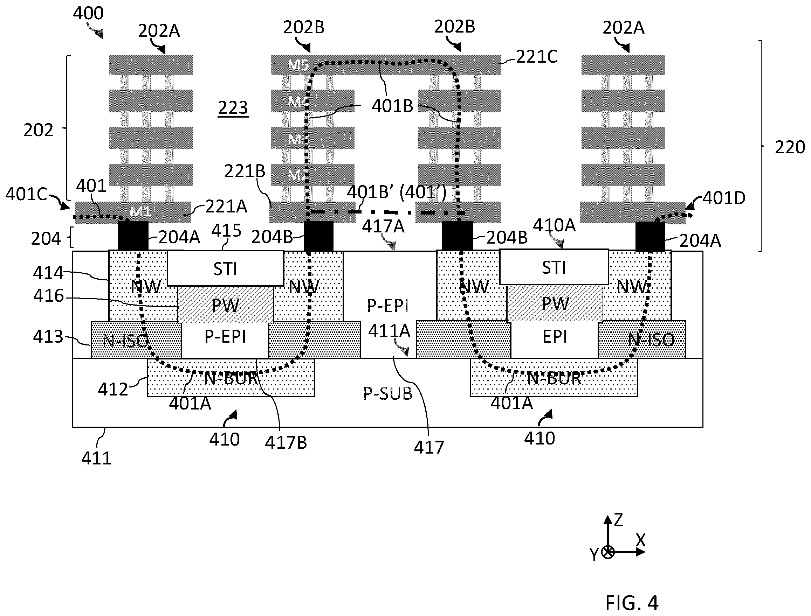

La figure 4 est une vue en coupe schématique et partielle illustrant un dispositif de détection de fissure 400 selon un autre mode de réalisation.

Le dispositif de détection de fissure 400 de la figure 4 a de nombreux éléments en commun avec le dispositif de détection de fissure 200 de la figure 2 et seules les différences entre les deux dispositifs de détection de fissure sont détaillées dans la description qui suit.

Le dispositif de détection de fissure 400 de la figure 4 se distingue du dispositif de détection de fissure 200 de la figure 4 principalement par les structures semiconductrices 410 qui comprennent chacune une couche épitaxiale 417 sur le substrat semiconducteur 411 dans lesquelles sont réalisées des implantations de type P et N, comme détaillé dans ce qui suit. Ceci permet d'avoir des régions semiconductrices enterrées encore plus profondément que dans la figure 2.

Chaque structure semiconductrice 410 comprend une première région semiconductrice enterrée 412 (N-BUR) formée dans un substrat semiconducteur 411 et dopée du deuxième type de dopage, opposé au type de dopage du substrat semiconducteur 411. Dans l'exemple représenté, le substrat semiconducteur 411 est dopé du type P et la première région semiconductrice enterrée 412 est dopée du type N. Par exemple, la première région semiconductrice enterrée 412 affleure au niveau de la face supérieure 411A du substrat semiconducteur 411.

La structure semiconductrice 410 comprend en outre une couche épitaxiale 417 (P-EPI) positionnée sur la face supérieure 411A du substrat semiconducteur 411. La couche épitaxiale 417 est faiblement dopée du premier type de dopage, dans l'exemple du type P.

Une tranchée isolante 415, par exemple du type tranchée isolante peu profonde (STI), est formée à partir de la face supérieure 417A de la couche épitaxiale 417. La tranchée isolante 415 est par exemple du même type que la tranchée isolante 215 de la figure 2.

Dans cette structure semiconductrice 410, la face supérieure 410A de la structure semiconductrice 410 correspond à la face supérieure 417A de la couche épitaxiale 417, et non à la face supérieure 411A du substrat semiconducteur 411.

Un caisson semiconducteur 416 est localisé dans la couche épitaxiale 417 sous la tranchée isolante 415. Le caisson semiconducteur 416 est plus fortement dopé du premier type de dopage que la couche épitaxiale 417, dans l'exemple du type P.

Sous le caisson semiconducteur 416, entre le caisson semiconducteur 416 et la première région semiconductrice enterrée 412, une portion 417B de la couche épitaxiale 417 faiblement dopée du premier type de dopage est de préférence conservée, pour former une diode bloquant le passage du courant. La portion 417B est entourée par une deuxième région semiconductrice enterrée 413 (N-ISO) dopée du deuxième type de dopage, dans l'exemple du type N.

La portion 417B de la couche épitaxiale 417 est moins large que la première région semiconductrice enterrée 412, et est centrée par rapport à la première région semiconductrice enterrée 412, de sorte que la deuxième région semiconductrice enterrée 413 comprend des zones de contact avec la première région semiconductrice enterrée 412. Ainsi, on obtient une continuité électrique, ou un canal de conduction électrique.

La tranchée isolante 415 (STI) et le caisson semiconducteur 416 sont entourés latéralement (selon les directions X et Y) par un caisson semiconducteur annulaire 414 (NW) dopé du deuxième type de dopage, dans l'exemple du type N.

Le caisson semiconducteur annulaire 414 s'étend depuis la face supérieure 417A de la couche épitaxiale 417 en profondeur jusqu'à la deuxième région semiconductrice enterrée 413. Ainsi, le caisson semiconducteur annulaire 414 de type N est en contact avec la deuxième région semiconductrice enterrée 413 de type N, elle-même en contact avec la première région semiconductrice enterrée 412 de type N. Ainsi, les régions semiconductrices 412, 413, 414 dopées de type N forment une portion conductrice 401A dans chaque structure semiconductrice 410, isolées des autres régions qui sont soit de type P, soit isolantes. Cette portion conductrice 401A forme une première portion d'une ligne conductrice 401.

Une telle structure semiconductrice 410 permet d'avoir une région semiconductrice enterrée localisée plus profondément que les structures semiconductrices précédemment décrites, par exemple à une profondeur qui peut être supérieure à 5 µm.

Un exemple simplifié de procédé de formation d'une structure semiconductrice 410 comprend :
- une implantation à partir de la face supérieure 411A du substrat semiconducteur 411 pour former la première région semiconductrice enterrée 412, cette implantation étant du deuxième type de dopage, opposé au type de dopage du substrat semiconducteur 411, dans cet exemple l'implantation est du type N : cette implantation peut être précédée de la formation d'un masque pour masquer les zones du substrat semiconducteur 411 qui ne doivent pas être dopées N, voire d'un masque d'alignement ;
- une croissance épitaxiale à partir de la face supérieure 411A du substrat semiconducteur 411 pour former une couche épitaxiale 417 faiblement dopée du premier type de dopage, dans cet exemple du type P ;
- une gravure à partir de la face supérieure 417A de la couche épitaxiale 417 pour former une tranchée peu profonde dans la couche épitaxiale 417, puis un remplissage de cette tranchée, par exemple en oxyde de silicium, pour former la tranchée isolante 415 ;
- une implantation en profondeur dans la couche épitaxiale 417 à travers la tranchée isolante 415 pour former le caisson semiconducteur 416, cette implantation étant du premier type de dopage, dans cet exemple du type P, cette implantation étant par exemple réalisée de sorte à conserver une portion 417B de la couche épitaxiale 417 entre le caisson semiconducteur 416 et le substrat semiconducteur 411 ;
- une implantation en profondeur dans la couche épitaxiale 417 jusqu'au substrat semiconducteur 411, et autour de la portion 417B de la couche épitaxiale 417, pour former la deuxième région semiconductrice enterrée 413, cette implantation étant du deuxième type de dopage, dans cet exemple du type N ;
- une implantation à partir de la face supérieure 417A de la couche épitaxiale 417 jusqu'à la deuxième région semiconductrice enterrée 413 et autour de la tranchée isolante 415, pour former le caisson semiconducteur annulaire 414, cette implantation étant du deuxième type de dopage, dans cet exemple du type N.

Les autres caractéristiques et variantes décrites en relation avec la figure 2, par exemple les empilements métalliques 202, les contacts 204, la deuxième portion 201B de la ligne conductrice, peuvent s'appliquer au mode de réalisation de la figure 4. En particulier, similairement au mode de réalisation de la figure 2, la ligne conductrice 401 comprend en outre tout ou partie d'empilements métalliques 202 faisant partie d'une structure d'interconnexion 220 (BEOL) positionnée au-dessus du substrat semiconducteur 411. En outre, similairement au mode de réalisation de la figure 2, un premier contact 204A et un deuxième contact 204B, positionnés sur les caissons semiconducteurs annulaires 414 des structures semiconductrices 410 permettent de relier chacune des structures semiconductrices 410 à respectivement un premier empilement métallique 202A et un deuxième empilement métallique 202B, les deuxièmes empilements métalliques 202B entre les deux structures semiconductrices 410 étant reliés entre eux au dernier niveau de métallisation M5, ou à tout autre niveau de métallisation.

La ligne conductrice 401 comprend :
- les portions conductrices 401A (premières portions) formées par les régions semiconductrices 412, 413, 414 dopées N des structures semiconductrices 410 ;
- une deuxième portion 401B entre les premières portions 401A, la deuxième portion étant similaire à la deuxième portion 201A décrite en relation avec la figure 2, la deuxième portion 401B étant reliée à chacune des premières portions 401A par un des deuxièmes contacts 204B ; et
- les segments conducteurs 221A des premiers empilements métalliques 202A reliés chacun à une des premières portions 401A par un des premiers contacts 204A.

Similairement à ce qui est décrit en relation avec la figure 2, la ligne conductrice 401 peut être reliée à un circuit de détection (non représenté). Par exemple, une première extrémité 401C de la ligne conductrice 401 peut être reliée à une première borne du circuit de détection au premier niveau de métallisation M1, et une deuxième extrémité 401D de la ligne conductrice 401 peut être reliée à une deuxième borne du circuit de détection au premier niveau de métallisation M1, mais la liaison peut être réalisée à tout autre niveau de métallisation. Le circuit de détection peut être configuré pour détecter un changement d'un paramètre électrique dans la ligne conductrice 401 indiquant la présence d'une fissure. Une extrémité de chaque segment conducteur 221A peut correspondre à une des première 401C et deuxième 401D extrémités de la ligne conductrice 401.

Un tel dispositif de détection 400 permet de détecter une fissure en profondeur jusqu'à dans une région semiconductrice enterrée des structures semiconductrices 410, la première région semiconductrice enterrée 412 ou la deuxième région semiconductrice enterrée 413 dans l'exemple de la figure 4. Plus largement, le dispositif de détection 400 permet de détecter une fissure le long de la ligne conductrice 401, entre la première région semiconductrice enterrée 412 et le niveau de métallisation supérieur M5. Pour détecter une fissure, on peut déterminer un changement de paramètre électrique dans la ligne conductrice 401, par exemple une augmentation de résistance lorsque la ligne conductrice est détériorée par une fissure dans une des régions semiconductrices 412, 413, 414, voire une résistance infinie lorsque la ligne conductrice 401 est interrompue. Une limite basse de résistance peut être définie pour déterminer si une fissure s'est produite.

Cette région semiconductrice enterrée peut être située à une profondeur supérieure à 4 µm, voire supérieure à 5 µm. Ainsi, le dispositif de détection 400 peut détecter une fissure jusqu'à une profondeur dépassant 5 µm.

Selon une variante pouvant s'appliquer notamment à chacun des modes de réalisation des figures 2 à 4, les deuxièmes empilements métalliques 202B entre les deux structures semiconductrices 210, 310, 410 pourraient être reliés entre eux par un segment conducteur au premier niveau de métallisation M1, au lieu d'être au dernier niveau de métallisation M5. Par exemple, les segments conducteurs 221B des deuxièmes empilements métalliques 202B pourraient être reliés entre eux, ou être un seul segment conducteur continu. Selon cette variante, la deuxième portion 201B', 301B', 401B' de la ligne conductrice 201', 301', 401' cheminerait uniquement au premier niveau de métallisation M1, comme représenté par la ligne en trait mixte dans les figures 2, 3, 4, et transiterait entre les deuxièmes empilements métalliques 202B au premier niveau de métallisation M1. La (première) ligne conductrice 201', 301', 401' pourrait donc ainsi cheminer pas plus haut que le premier niveau de métallisation M1, et non plus jusqu'au dernier niveau de métallisation M5. Cette variante peut ainsi permettre d'avoir moins de doute quant à la localisation d'une fissure détectée par la ligne conductrice 201', 301', 401' c'est-à-dire de pouvoir détecter une fissure dans une des structures semiconductrices ou dans le substrat semiconducteur, et non dans la structure d'interconnexion 220.

Selon une variante pouvant s'appliquer notamment à chacun des modes de réalisation des figures 2 à 4, les deuxièmes empilements métalliques 202B entre les deux structures semiconductrices 210, 310, 410 pourraient être reliés entre eux par un segment conducteur à tout autre niveau de métallisation.

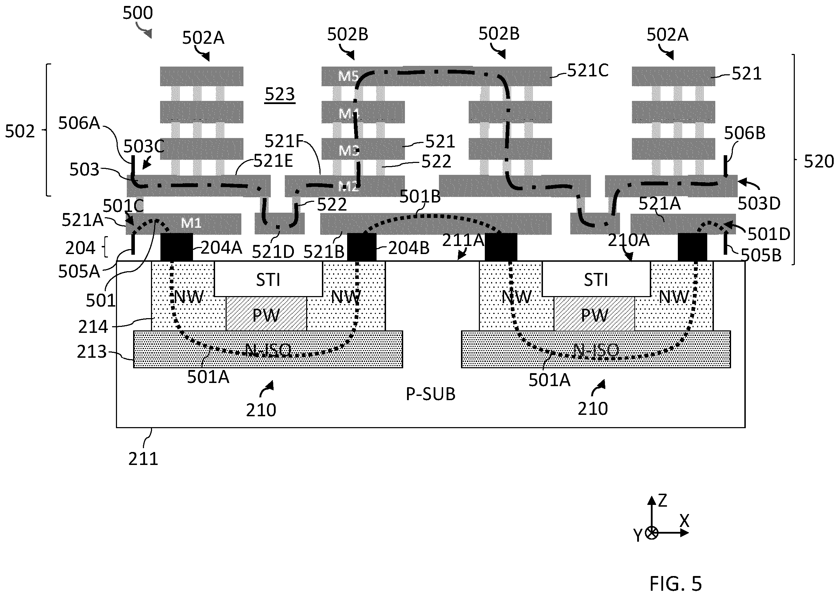

On va décrire en relation avec les figures 5 à 7 d'autres dispositifs de détection de fissure 500, 600, 700. Ces autres dispositifs de détection de fissure se distinguent des dispositifs de détection de fissure 200, 300, 400 des figures 2 à 4 principalement en ce qu'il n'y a pas une seule ligne conductrice mais deux lignes conductrices : une première ligne conductrice formée dans la structure d'interconnexion et dans chaque structure semiconductrice, et une deuxième ligne conductrice formée dans la structure d'interconnexion (mais pas dans les structures semiconductrices). La première ligne conductrice est destinée à détecter une fissure préférentiellement dans le substrat semiconducteur ou dans au moins une des structures semiconductrices. La deuxième ligne conductrice est destinée à détecter une fissure préférentiellement dans la structure d'interconnexion. Les première et deuxième lignes conductrices sont de préférence isolées entre elles. Les structures semiconductrices des figures 5, 6, 7 sont similaires respectivement aux structures semiconductrices des figures 2, 3, 4, elles ne sont donc pas décrites à nouveau, et conservent les mêmes références numériques dans les figures.

Dans les figures 5 à 7, la première ligne conductrice 501, 601, 701 est symbolisée par une ligne en pointillés qui permet de visualiser un chemin conducteur, parmi plusieurs chemins possibles le long de cette première ligne conductrice. La première ligne conductrice 501, 601, 701 n'est donc pas limitée à cette ligne en pontillés. Similairement, la deuxième ligne conductrice 503, 603, 703 est symbolisée par une ligne en traits mixtes qui permet de visualiser un chemin conducteur, parmi plusieurs chemins possibles le long de cette deuxième ligne conductrice. La deuxième ligne conductrice 503, 603, 703 n'est donc pas limitée à cette ligne en traits mixtes.

La figure 5 est une vue en coupe schématique et partielle illustrant un dispositif de détection de fissure 500 selon un autre mode de réalisation.

Le dispositif de détection de fissure 500 de la figure 5 a de nombreux éléments en commun avec le dispositif de détection de fissure 200 de la figure 2 et seules les différences entre les deux dispositifs de détection de fissure sont détaillées dans la description qui suit.

Le dispositif de détection de fissure 500 de la figure 5 se distingue du dispositif de détection de fissure 200 de la figure 2 principalement en ce que la première ligne conductrice 501 transite seulement au premier niveau de métallisation M1 de la structure d'interconnexion 520, et en ce qu'il comprend une deuxième ligne conductrice 503 qui transite dans tous les niveaux de métallisation M1-M5 de la structure d'interconnexion 520, mais qui ne transite pas dans les structures semiconductrices 210.

Similairement à la structure d'interconnexion 220 des figures 2 à 4, la structure d'interconnexion 520 comprend des segments conducteurs 521 à chaque niveau de métallisation M1-M5 et des vias conducteurs 522 entre les segments conducteurs 521 des différents niveaux de métallisation M1-M5. Les segments conducteurs 521 et les vias conducteurs 522 sont noyés dans une couche isolante 523. Les segments conducteurs 521 et les vias conducteurs 522 à partir du deuxième niveau de métallisation M2 sont agencés en plusieurs empilements métalliques 502. Les empilements métalliques 502 comprennent des troisièmes empilements métalliques 502A et des quatrièmes empilements métalliques 502B.

La première ligne conductrice 501 inclut des segments conducteurs 521A, 521B du premier niveau de métallisation M1 et des contacts 204, similaires aux contacts décrits en lien avec les figures 2 à 4. Les contacts 204 comprennent des premiers contacts 204A reliant chacune des structures semiconductrices 210 à un premier segment conducteur 521A, et des deuxièmes contacts 204B reliant chacune des structures semiconductrices 210 à un deuxième segment conducteur 521B. Chacune de ces liaisons par contact est réalisée au premier niveau de métallisation M1. En d'autres termes, les premiers et deuxième(s) segments conducteurs 521A, 521B font partie du premier niveau de métallisation M1. Les contacts 204 sont positionnés sur la face supérieure 210A des structures semiconductrices 210, qui correspond dans la figure 5 à la face supérieure 211A du substrat semiconducteur 211. En particulier, les contacts 204 sont positionnés sur les caissons semiconducteurs annulaires 214 des structures semiconductrices 210, de sorte que chaque caisson semiconducteur annulaire 214 est relié à des premier et deuxième segments conducteurs 521A, 521B.

Les deuxièmes segments conducteurs 521B entre les deux structures semiconductrices 210 sont reliés entre eux au premier niveau de métallisation M1, ou forment un seul deuxième segment conducteur continu 521B.

La première ligne conductrice 501 comprend :
- des premières portions 501A formées par les régions semiconductrices 213, 214 dopées N des structures semiconductrices 210, similaires aux premières portions 201A de la figure 2 ;
- une deuxième portion 501B entre les premières portions 501A, la deuxième portion étant formée par le deuxième segment conducteur 521B au premier niveau de métallisation M1, similairement à la deuxième portion 201B' selon la variante décrite précédemment en lien avec les figures 2 à 4, la deuxième portion 501B étant reliée à chacune des premières portions 501A par un des deuxièmes contacts 204B ; et
- les premiers segments conducteurs 521A reliés aux premières portions 501A par les premiers contacts 204A.

La première ligne conductrice 501 peut être reliée à un premier circuit de détection dont on a représenté des bornes 505A, 505B. Par exemple, une première extrémité 501C de la première ligne conductrice 501 peut être reliée à une première borne 505A du premier circuit de détection au premier niveau de métallisation M1, et une deuxième extrémité 501D de la première ligne conductrice 501 peut être reliée à une deuxième borne 505B du premier circuit de détection au premier niveau de métallisation M1. Le premier circuit de détection peut être configuré pour détecter un changement d'un paramètre électrique dans la première ligne conductrice 501 indiquant la présence d'une fissure dans le substrat semiconducteur 211. Une extrémité de chaque segment conducteur 521A peut correspondre à une des première 501C et deuxième 501D extrémités de la première ligne conductrice 501.

La première ligne conductrice 501 emprunte les segments conducteurs 521A, 521B seulement au premier niveau de métallisation M1, de manière à détecter une fissure préférentiellement dans les structures semiconductrices 210.

La première ligne conductrice 501 permet de détecter une fissure en profondeur jusqu'à dans une région semiconductrice enterrée du substrat semiconducteur 211, la région semiconductrice enterrée 213, similairement à ce qui est décrit en lien avec la figure 2. Plus largement, le dispositif de détection 500 permet de détecter une fissure le long de la première ligne conductrice 501, entre la région semiconductrice enterrée 213 et le premier niveau de métallisation M1. Pour détecter une fissure, on peut déterminer un changement de paramètre électrique dans la première ligne conductrice 501, par exemple une augmentation de résistance lorsque la première ligne conductrice 501 est détériorée par une fissure dans une des régions semiconductrices 213, 214, voire une résistance infinie lorsque la première ligne conductrice 501 est interrompue. Une première limite basse de résistance peut être définie pour déterminer si une fissure s'est produite le long de la première ligne conductrice 501.

La deuxième ligne conductrice 503 comprend un segment conducteur 521E (cinquième segment conducteur) du deuxième niveau de métallisation M2 de chaque troisième empilement métallique 502A et un segment conducteur 521F (sixième segment conducteur) du deuxième niveau de métallisation M2 de chaque quatrième empilement métallique 502B, et d'autres segments conducteurs 521 des troisième à dernier niveaux de métallisation M3-M5 pour chaque quatrième empilement métallique 502B, les segments conducteurs de chaque quatrième empilement métallique 502B étant reliés entre eux par des vias conducteurs 522. Les cinquième et sixième segments conducteurs 521E, 521F adjacents sont reliés entre eux par un segment conducteur 521D (quatrième segment conducteur) du premier niveau de métallisation M1 et par des vias conducteurs 522, reliant ainsi les troisième et quatrième empilements métalliques 502A, 502B adjacents. Le quatrième segment conducteur 521D est isolé des premiers et deuxième(s) segments conducteurs 521A, 521B faisant partie de la première ligne conductrice 501. Ainsi, la deuxième ligne conductrice 503 est isolée de la première ligne conductrice 501. Les quatrièmes empilements métalliques 502B adjacents sont reliés entre eux au dernier niveau de métallisation M5 par un segment conducteur 521C (septième segment conducteur) qui est continu entre ces quatrièmes empilements métalliques.

La deuxième ligne conductrice 503 transite ainsi entre le premier niveau de métallisation M1 et le dernier niveau de métallisation M5, de manière à détecter une fissure à tous les niveaux de métallisation de la structure d'interconnexion 520.

En variante, les troisième et quatrième empilements métalliques 502A, 502B adjacents pourraient être reliés entre eux par un segment conducteur du deuxième niveau de métallisation M2. Par exemple, les cinquième et sixième segments conducteurs 521E, 521F adjacents pourraient être directement reliés entre eux. Selon cette variante, la deuxième ligne conductrice 503 pourrait détecter une fissure entre le deuxième niveau de métallisation M2 et le dernier niveau de métallisation M5 de la structure d'interconnexion 520.

En variante, les quatrièmes empilements métalliques 502B adjacents pourraient être reliés entre eux à un niveau de métallisation inférieur au dernier niveau de métallisation M5.

La deuxième ligne conductrice 503 peut être reliée à un deuxième circuit de détection dont on a représenté des bornes 506A, 506B. Par exemple, une première extrémité 503C de la deuxième ligne conductrice 503 peut être reliée à une première borne 506A du deuxième circuit de détection au deuxième niveau de métallisation M2, et une deuxième extrémité 503D de la deuxième ligne conductrice 503 peut être reliée à une deuxième borne 505B du deuxième circuit de détection au deuxième niveau de métallisation M2. Le deuxième circuit de détection pourrait être relié à la deuxième ligne conductrice à un niveau de métallisation plus élevé. Le deuxième circuit de détection peut être configuré pour détecter un changement d'un paramètre électrique dans la deuxième ligne conductrice 503 indiquant la présence d'une fissure dans la structure d'interconnexion 520. Une extrémité de chaque segment conducteur 521E peut correspondre à une des première 503C et deuxième 503D extrémités de la deuxième ligne conductrice 503.

Pour détecter une fissure, on peut déterminer un changement de paramètre électrique dans la deuxième ligne conductrice 503, par exemple une augmentation de résistance, voire une résistance infinie. Une deuxième limite basse de résistance peut être définie pour déterminer si une fissure s'est produite le long de la deuxième ligne conductrice 503.

La deuxième limite basse de résistance peut être inférieure à la première limite basse de résistance.

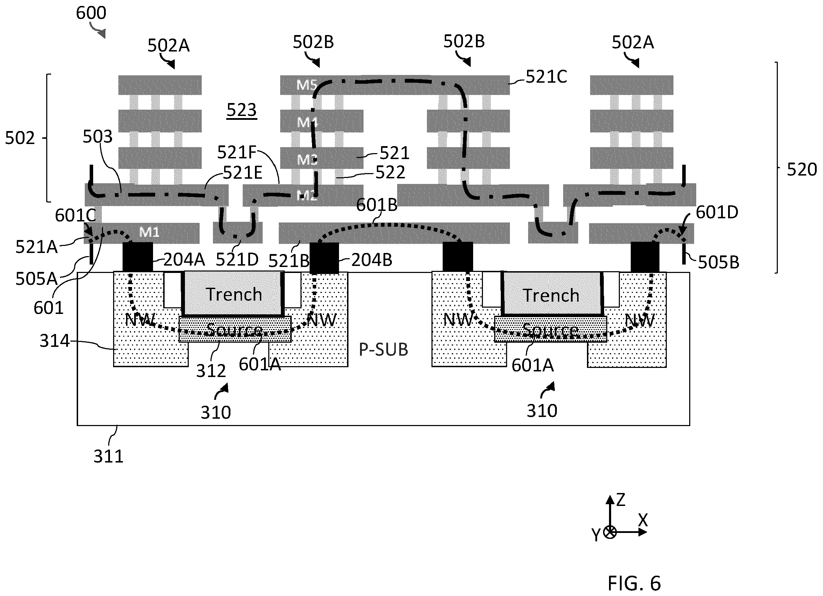

La figure 6 est une vue en coupe schématique et partielle illustrant un dispositif de détection de fissure 600 selon un autre mode de réalisation.

Le mode de réalisation de la figure 6 se distingue du mode de réalisation de la figure 5 en ce que les structures semiconductrices 310, similaires à celles de la figure 3, remplacent les structures semiconductrices 210.

Ainsi, la première ligne conductrice 601 comprend :
- des premières portions 601A formées par les régions semiconductrices 312, 314 dopées N des structures semiconductrices 310, similaires aux premières portions 301A de la figure 3 ;
- une deuxième portion 601B entre les premières portions 601A, la deuxième portion étant formée par le deuxième segment conducteur 521B au premier niveau de métallisation M1, similairement à la deuxième portion 301B' selon la variante décrite précédemment en lien avec les figures 2 à 4, la deuxième portion 601B étant reliée à chacune des premières portions 601A par un des deuxièmes contacts 204B ; et
- les premiers segments conducteurs 521A reliés aux premières portions 601A par les premiers contacts 204A.

La première ligne conductrice 601 emprunte les segments conducteurs 521A, 521B seulement au premier niveau de métallisation M1, de manière à détecter une fissure préférentiellement dans les structures semiconductrices 310.

La première ligne conductrice 601 peut être reliée à un premier circuit de détection dont on a représenté des bornes 505A, 505B. Par exemple, une première extrémité 601C de la première ligne conductrice 601 peut être reliée à une première borne 505A du premier circuit de détection au premier niveau de métallisation M1, et une deuxième extrémité 601D de la ligne conductrice 601 peut être reliée à une deuxième borne 505B du premier circuit de détection au premier niveau de métallisation M1. Le premier circuit de détection peut être configuré pour détecter un changement d'un paramètre électrique dans la première ligne conductrice 601 indiquant la présence d'une fissure dans le substrat semiconducteur 311. Une extrémité de chaque segment conducteur 521A peut correspondre à une des première 601C et deuxième 601D extrémités de la première ligne conductrice 601.

La première ligne conductrice 601 permet de détecter une fissure en profondeur jusqu'à dans une région semiconductrice enterrée du substrat semiconducteur 311, la région semiconductrice enterrée 312, similairement à ce qui est décrit en lien avec la figure 3. Plus largement, le dispositif de détection 600 permet de détecter une fissure le long de la première ligne conductrice 601, entre la région semiconductrice enterrée 312 et le premier niveau de métallisation M1. Pour détecter une fissure, on peut déterminer un changement de paramètre électrique dans la première ligne conductrice 601, par exemple une augmentation de résistance lorsque la première ligne conductrice 601 est détériorée par une fissure dans une des régions semiconductrices 312, 314, voire une résistance infinie lorsque la première ligne conductrice 601 est interrompue. Une première limite basse de résistance peut être définie pour déterminer si une fissure s'est produite le long de la première ligne conductrice 601.

La deuxième ligne conductrice 503 est similaire à celle décrite en lien avec la figure 5, les variantes décrites pouvant s'appliquer.

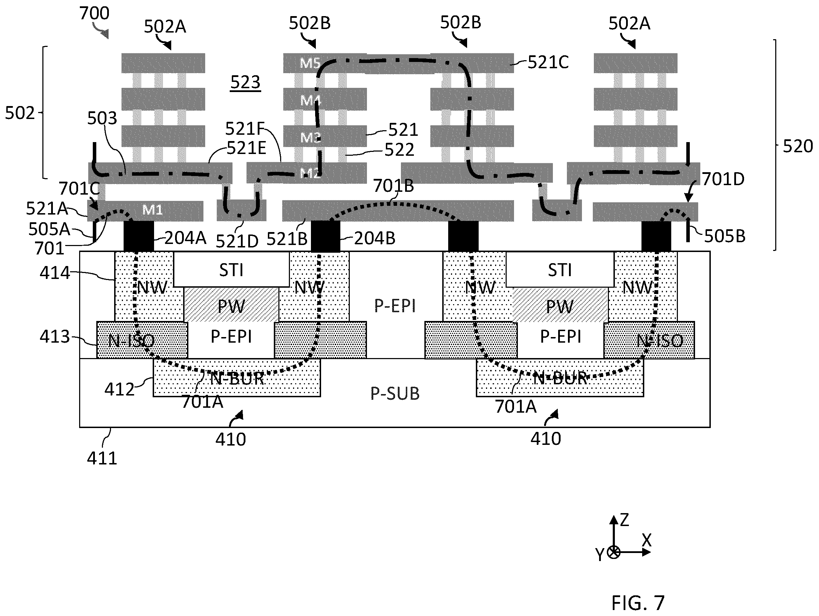

La figure 7 est une vue en coupe schématique et partielle illustrant un dispositif de détection de fissure 700 selon un autre mode de réalisation.

Le mode de réalisation de la figure 7 se distingue du mode de réalisation de la figure 5 en ce que les structures semiconductrices 410, similaires à celles de la figure 4, remplacent les structures semiconductrices 210.

Ainsi, la première ligne conductrice 701 comprend :
- des premières portions 701A formées par les régions semiconductrices 412, 413, 414 dopées N des structures semiconductrices 410, similaires aux premières portions 401A de la figure 4 ;
- une deuxième portion 701B entre les premières portions 701A, la deuxième portion étant formée par le deuxième segment conducteur 521B au premier niveau de métallisation M1, similairement à la deuxième portion 401B' selon la variante décrite précédemment en lien avec les figures 2 à 4, la deuxième portion 701B étant reliée à chacune des premières portions 701A par un des deuxièmes contacts 204B ; et
- les premiers segments conducteurs 521A reliés aux premières portions 701A par les premiers contacts 204A.

La première ligne conductrice 701 emprunte les segments conducteurs 521A, 521B seulement au premier niveau de métallisation M1, de manière à détecter une fissure préférentiellement dans les structures semiconductrices 410.

La première ligne conductrice 701 peut être reliée à un premier circuit de détection dont on a représenté des bornes 505A, 505B. Par exemple, une première extrémité 701C de la première ligne conductrice 701 peut être reliée à une première borne 505A du premier circuit de détection au premier niveau de métallisation M1, et une deuxième extrémité 701D de la première ligne conductrice 701 peut être reliée à une deuxième borne 505B du premier circuit de détection au premier niveau de métallisation M1. Le premier circuit de détection peut être configuré pour détecter un changement d'un paramètre électrique dans la première ligne conductrice 701 indiquant la présence d'une fissure dans au moins une des structures semiconductrices 410. Une extrémité de chaque segment conducteur 521A peut correspondre à une des première 701C et deuxième 701D extrémités de la première ligne conductrice 701.

La première ligne conductrice 701 permet de détecter une fissure en profondeur jusqu'à dans une région semiconductrice enterrée des structures semiconductrices 410, par exemple dans la première région semiconductrice enterrée 412 ou la deuxième région semiconductrice enterrée 413, similairement à ce qui est décrit en lien avec la figure 4. Plus largement, le dispositif de détection 700 permet de détecter une fissure le long de la première ligne conductrice 701, entre la première région semiconductrice enterrée 412 et le premier niveau de métallisation M1. Pour détecter une fissure, on peut déterminer un changement de paramètre électrique dans la première ligne conductrice 701, par exemple une augmentation de résistance lorsque la première ligne conductrice 701 est détériorée par une fissure dans une des régions semiconductrices 412, 413, 414, voire une résistance infinie lorsque la première ligne conductrice 701 est interrompue. Une première limite basse de résistance peut être définie pour déterminer si une fissure s'est produite le long de la première ligne conductrice 701.

La deuxième ligne conductrice 503 est similaire à celle décrite en lien avec la figure 5, les variantes décrites pouvant s'appliquer.

Dans les exemples des figures 2 à 7, on a représenté à titre d'exemple quatre empilements métalliques, mais il pourrait y en avoir plus, par exemple lorsqu'il y a plus de deux structures semiconductrices, voire moins, par exemple lorsqu'il y a une structure semiconductrice. De nombreuses variantes d'empilements métalliques, voire d'autres structures conductrices dans la structure d'interconnexion, pourront être envisagées par une personne du métier.

Dans tous les modes de réalisation décrits, et plus généralement pour un dispositif de détection de fissure selon un mode de réalisation, ou une puce électronique selon un mode de réalisation, la couche isolante de la structure d'interconnexion peut être en un oxyde, par exemple un oxyde de silicium. En variante et de manière avantageuse, la couche isolante de la structure d'interconnexion peut être en un ou en un matériau diélectrique du type low-κ, c'est-à-dire un matériau ayant une constante diélectrique κ faible comparée à celle du dioxyde de silicium, voire un matériau diélectrique du type ultra-low-x. En effet, ce type de matériau diélectrique peut conduire à des fissures, auquel cas, un dispositif de détection est particulièrement intéressant.

Les modes de réalisation permettent de détecter des fissures en profondeur dans le substrat semiconducteur, ou la structure semiconductrice formée dans et/ou sur le substrat semiconducteur (niveau FEOL). Des modes de réalisation permettent aussi de détecter des fissures dans la structure d'interconnexion (BEOL). Des modes de réalisation permettent de distinguer une fissure au niveau FEOL d'une fissure au niveau BEOL, et ce, sans nécessairement augmenter la surface occupée par le dispositif de détection.

Dans les modes de réalisation décrits, on voit que le dispositif de détection peut être réalisé en utilisant des techniques de fabrication de la microélectronique, par exemple des lignes de fabrication déjà existantes selon les structures semiconductrices fabriquées. Par exemple, le dispositif de détection peut être réalisé sans rajouter d'étapes complémentaires, dans la mesure où il est déjà prévu de fabriquer la structure d'interconnexion et les structures semiconductrices.

Les modes de réalisation sont adaptés à la co-intégration de plusieurs structures semiconductrices, par exemple différentes, formées dans et/ou sur un même substrat semiconducteur. Tout ou partie des trois structures semiconductrices décrites dans les figures 2 à 7 peuvent notamment être co-intégrées dans et/ou sur un même substrat semiconducteur. Par exemple, la co-intégration comprend au moins une mémoire eSTM. Par exemple, les structures semiconductrices du type triple well et du type à grille verticale d'une mémoire eSTM peuvent être co-intégrées.

Les modes de réalisation décrits ci-après sont tout particulièrement adaptés à la détection de fissures dans les puces électroniques, en particulier lors de l'individualisation de puces électroniques par découpe, par exemple par découpe laser, d'une tranche semiconductrice. Ainsi, les modes de réalisation peuvent trouver de nombreuses applications.

Les modes de réalisation décrits ci-dessus peuvent être utilisés dans de nombreux types de marchés industriels, par exemple :
- l'industrie automobile, par exemple dans le domaine de l'électrification automobile ou dans le domaine des systèmes avancés d'aide à la conduite (Advanced Driver Assistance Systems - ADAS) ;
- le domaine industriel, par exemple dans le domaine de l'énergie verte, dans le domaine de l'électrification des infrastructures, de l'internet des objets (Internet of Things
- IoT) et des maisons intelligentes (SmartHome) ;
- l'industrie de l'électronique personnelle, par exemple dans le domaine de la téléphonie mobile et de l'internet des objets (Internet of Things - IoT), ainsi que dans le domaine des interfaces haut débit ;
- l'industrie des équipements de communication, des ordinateurs et des périphériques, par exemple dans le domaine des infrastructures et des centres de données (Data Centers), et dans le domaine des satellites en orbite terrestre basse (Low Earth Orbit - LEO).

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, on a représenté deux structures semiconductrices similaires dans et/ou sur le substrat semiconducteur dans lesquelles la (première) ligne conductrice du dispositif de détection transite. Plusieurs autres variantes pourront être envisagées par la personne du métier. Selon une variante, la (première) ligne conductrice du dispositif de détection pourrait transiter par une seule structure semiconductrice. Dans ce cas, la ligne conductrice pourrait ne transiter que jusqu'au premier niveau de métallisation de la structure d'interconnexion. Selon une autre variante, des structures semiconductrices différentes pourraient être formées dans et/ou sur le substrat semiconducteur, et la (première) ligne conductrice du dispositif de détection pourrait alors transiter par ces structures semiconductrices différentes.

Enfin, la mise en oeuvre pratique des modes de réalisation et variantes décrits est à la portée de la personne du métier à partir des indications fonctionnelles données ci-dessus.

## Revendications

1. Dispositif de détection de fissure (200 ; 300 ; 400 ; 500 ; 600 ; 700) adapté à détecter une fissure dans une puce électronique, le dispositif de détection de fissure comprenant une première ligne conductrice (201 ; 301 ; 401 ; 501 ; 601 ; 701) pour détecter une fissure dans au moins une structure semiconductrice (210 ; 310 ; 410) située dans, et/ou sur, un substrat semiconducteur (211 ; 311 ; 411), une structure d'interconnexion (220 ; 520) étant reliée à une première face (210A ; 310A ; 410A) de la au moins une structure semiconductrice, la première ligne conductrice étant comprise dans la structure d'interconnexion et dans la au moins une structure semiconductrice, la première ligne conductrice comprenant :
- au moins un premier segment conducteur (221A ; 521A) et au moins un deuxième segment conducteur (221B ; 521B), lesdits au moins un premier et deuxième segments conducteurs étant d'un premier niveau de métallisation (M1) de la structure d'interconnexion et étant électriquement isolés entre eux par une couche isolante (223 ; 523) ; et
- une région conductrice enterrée (213 ; 312 ; 412, 413) en profondeur dans chaque structure semiconductrice, ladite région conductrice enterrée étant reliée à un du au moins un premier segment conducteur et un du au moins un deuxième segment conducteur, une région isolante (215 ; 315, 318 ; 415) étant positionnée entre la première face de chaque structure semiconductrice et la région conductrice enterrée.

2. Dispositif selon la revendication 1, dans lequel le substrat semiconducteur (211 ; 311 ; 411) est dopé d'un premier type de conductivité, la région conductrice enterrée (213 ; 312 ; 412, 413) étant une région semiconductrice dopée d'un deuxième type de conductivité opposé au premier type de conductivité.

3. Dispositif selon la revendication 2, dans lequel chaque structure semiconductrice (210 ; 310 ; 410) comprend :
- un caisson semiconducteur (214 ; 314 ; 414) dopé du deuxième type de conductivité, et s'étendant en profondeur depuis la première face (210A ; 310A ; 410A) de chaque structure semiconductrice de manière à relier électriquement ladite première face et la région conductrice enterrée (213 ; 312 ; 412, 413) ;
- des éléments conducteurs (204) reliés à la première face de chaque structure semiconductrice, les éléments conducteurs comprenant un premier élément conducteur (204A) reliant le caisson semiconducteur au premier segment conducteur (221A ; 521A), et un deuxième élément conducteur (204B) reliant le caisson semiconducteur au deuxième segment conducteur (221B ; 521B).

4. Dispositif selon l'une quelconque des revendications 1 à 3, dans lequel la région conductrice enterrée est à une profondeur supérieure à 0,5 µm, par exemple supérieure ou égale à 1 µm, ou supérieure ou égale à 3 µm, ou encore supérieure ou égale à 5 µm.

5. Dispositif selon l'une quelconque des revendications 1 à 4, dans lequel chaque premier segment conducteur (221A) est inclus dans un premier empilement métallique (202A) comprenant plusieurs niveaux de métallisation de la structure d'interconnexion, et chaque deuxième segment conducteur (221B) est inclus dans un deuxième empilement métallique (202B) comprenant plusieurs niveaux de métallisation de la structure d'interconnexion.

6. Dispositif selon l'une quelconque des revendications 1 à 5, dans lequel la au moins une structure semiconductrice (210 ; 310 ; 410) comprend plusieurs structures semiconductrices, le au moins un premier segment conducteur (221A ; 521A) comprenant plusieurs premiers segments conducteurs et le au moins un deuxième segment conducteur (221B ; 521B) comprenant plusieurs deuxièmes segments conducteurs, les deuxièmes segments conducteurs entre deux structures semiconductrices adjacentes parmi les structures semiconductrices étant reliés entre eux dans la structure d'interconnexion (220 ; 520).

7. Dispositif selon la revendication 6, dans lequel les deuxièmes segments conducteurs (521B) sont reliés entre eux au premier niveau de métallisation (M1) de la structure d'interconnexion.

8. Dispositif selon la revendication 6 dans sa dépendance avec la revendication 5, dans lequel les deuxièmes empilements métalliques (202B) entre les deux structures semiconductrices adjacentes sont reliés entre eux par un troisième segment conducteur (221C) d'un niveau de métallisation de la structure d'interconnexion supérieur au premier niveau de métallisation.

9. Dispositif selon l'une quelconque des revendications 1 à 8, dans lequel la première ligne conductrice (201 ; 301 ; 401) est également adaptée à détecter une fissure dans la structure d'interconnexion (220).

10. Dispositif selon l'une quelconque des revendications 1 à 4, 6, 7 et 9, comprenant en outre une deuxième ligne conductrice (503) pour détecter une fissure dans la structure d'interconnexion (520), ladite deuxième ligne conductrice étant comprise dans la structure d'interconnexion (520) et étant distincte de la première ligne conductrice (501 ; 601 ; 701).

11. Dispositif selon la revendication 10, dans lequel la deuxième ligne conductrice (503) comprend :
- au moins un quatrième segment conducteur (521D) du premier niveau de métallisation (M1) de la structure d'interconnexion (520), chaque quatrième segment conducteur étant isolé des au moins un premier et au moins un deuxième segments conducteurs par la couche isolante (523) ;
- au moins un cinquième segment conducteur (521E) d'un niveau de métallisation de la structure d'interconnexion supérieur au premier niveau de métallisation ;
- au moins un sixième segment conducteur (521E) d'un niveau de métallisation de la structure d'interconnexion supérieur au premier niveau de métallisation ;
chaque quatrième segment conducteur reliant un du au moins un cinquième segment conducteur à un du au moins un sixième segment conducteur, par exemple par l'intermédiaire de vias conducteurs (522) de la structure d'interconnexion.

12. Dispositif selon la revendication 11, dans lequel chaque cinquième segment conducteur (521E) est inclus dans un troisième empilement métallique (502A) comprenant plusieurs niveaux de métallisation de la structure d'interconnexion (520) à partir du deuxième niveau de métallisation (M2), et/ou chaque sixième segment conducteur (521F) est inclus dans un quatrième empilement métallique (502B) comprenant plusieurs niveaux de métallisation de la structure d'interconnexion à partir du deuxième niveau de métallisation (M2), par exemple deux quatrièmes empilements métalliques (502B) adjacents étant reliés entre eux à un niveau de métallisation supérieur au deuxième niveau de métallisation par un septième segment conducteur (521C).

13. Dispositif selon l'une quelconque des revendications 10 à 12, dans lequel la deuxième ligne conductrice (503) comprend une première extrémité (503C) reliée à une première borne (506A) d'un deuxième circuit de détection et une deuxième extrémité (503D) reliée à une deuxième borne (506B) du deuxième circuit de détection, de manière à mesurer un signal électrique dans ladite deuxième ligne conductrice pour déterminer une présence d'une fissure.

14. Dispositif selon l'une quelconque des revendications 1 à 13, dans lequel la première ligne conductrice (201 ; 301 ; 401 ; 501 ; 601 ; 701) comprend une première extrémité (201C ; 301C ; 401C ; 501C ; 601C ; 701C) reliée à une première borne (505A) d'un premier circuit de détection et une deuxième extrémité (201D ; 301D ; 401D ; 501D ; 601D ; 701D) reliée à une deuxième borne (505B) du premier circuit de détection, de manière à mesurer un signal électrique dans ladite première ligne conductrice pour déterminer une présence d'une fissure.

15. Dispositif selon la revendication 14 dans sa dépendance avec la revendication 13, dans lequel la deuxième borne (506B) du deuxième circuit de détection est isolée électriquement de la deuxième borne (505B) du premier circuit de détection, par exemple la première borne (506A) du deuxième circuit de détection est reliée électriquement à la première borne (505A) du premier circuit de détection.

16. Dispositif selon l'une quelconque des revendications 10 à 15, dans lequel la couche isolante (230) comprend un matériau à constante diélectrique faible comparée à la constante diélectrique du dioxyde de silicium.

17. Puce électronique comprenant :
- un substrat semiconducteur (211 ; 311 ; 411) ;
- au moins une structure semiconductrice (210 ; 310 ; 410) située dans, et/ou sur, le substrat semiconducteur ;
- une structure d'interconnexion (220 ; 520) reliée à une première face (210A ; 310A ; 410A) de la au moins une structure semiconductrice ; et
- un dispositif de détection de fissure selon l'une quelconque des revendications 1 à 16.

18. Puce électronique selon la revendication 17, dans laquelle :
- la au moins une structure semiconductrice (210 ; 310 ; 410) comprend plusieurs structures semiconductrices, au moins une structure semiconductrice parmi lesdites structures semiconductrices comprenant une structure de grille verticale d'un transistor de sélection enterré d'une cellule de mémoire intégrée à transistor de sélection en tranchée ; et/ou
- le dispositif de détection de fissure est positionné en périphérie de la puce électronique, par exemple autour d'une région de circuits électroniques de la puce électronique, par exemple dans un anneau de scellement de la puce électronique.

19. Procédé d'utilisation du dispositif de détection de fissure selon l'une quelconque des revendications 1 à 16, le procédé comprenant :
- l'émission d'un premier signal électrique à une première extrémité (201C ; 301C ; 401C ; 501C ; 601C ; 701C) de la première ligne conductrice (201 ; 301 ; 401 ; 501 ; 601 ; 701) ;
- la réception du premier signal électrique à une deuxième extrémité (201D ; 301D ; 401D ; 501D ; 601D ; 701D) de la première ligne conductrice, et la mesure d'une première valeur de résistance du premier signal électrique reçu ;
- la comparaison de la première valeur de résistance mesurée avec une première limite basse de résistance pour déterminer une présence d'une fissure dans la première ligne conductrice.

20. Procédé d'utilisation selon la revendication 19 pour un dispositif de détection de fissure selon l'une quelconque des revendications 10 à 13 et 15, le procédé comprenant :
- l'émission d'un deuxième signal électrique à une première extrémité (503C) de la deuxième ligne conductrice (503 ; 603 ; 703) ;
- la réception du deuxième signal électrique à une deuxième extrémité (503B) de la deuxième ligne conductrice, et la mesure d'une deuxième valeur de résistance du deuxième signal électrique reçu ;
- la comparaison de la deuxième valeur de résistance mesurée avec une deuxième limite basse de résistance pour déterminer une présence d'une fissure dans la deuxième ligne conductrice ;
la première limite basse de résistance étant par exemple supérieure à la deuxième limite basse de résistance.

21. Procédé de co-intégration de plusieurs structures semiconductrices (210 ; 310 ; 410) dans, et/ou sur, un même substrat semiconducteur (211; 311; 411), le procédé comprenant en outre la formation d'une structure d'interconnexion (220 ; 520) reliée à une première face (210A ; 310A ; 410A) des structures semiconductrices, et d'un dispositif de détection de fissure selon l'une quelconque des revendications 1 à 16, au moins une structure semiconductrice parmi les structures semiconductrices comprenant une structure de grille verticale d'un transistor de sélection enterré d'une cellule de mémoire intégrée à transistor de sélection en tranchée.
